(19) Europäisches Patentamt / European Patent Office / Office européen des brevets

(11) **EP 3 658 921 B1**

(12) **FASCICULE DE BREVET EUROPEEN**

(45) Date de publication et mention
de la délivrance du brevet:
**21.04.2021 Bulletin 2021/16**

(21) Numéro de dépôt: **18758934.6**

(22) Date de dépôt: **26.07.2018**

(51) Int Cl.:
*G01R 35/00* (2006.01)     *G01R 33/02* (2006.01)
*G01P 21/00* (2006.01)     *G01V 13/00* (2006.01)
*G01C 25/00* (2006.01)     *G01C 17/38* (2006.01)

(86) Numéro de dépôt international:
**PCT/FR2018/051914**

(87) Numéro de publication internationale:
**WO 2019/020945 (31.01.2019 Gazette 2019/05)**

(54) **PROCÉDÉ DE CALIBRATION D'UN MAGNETOMETRE**

VERFAHREN ZUR KALIBRIERUNG EINES MAGNETOMETERS

METHOD FOR CALIBRATING A MAGNETOMETER

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.07.2017 FR 1757082**

(43) Date de publication de la demande:
**03.06.2020 Bulletin 2020/23**

(73) Titulaire: **SYSNAV
27200 Vernon (FR)**

(72) Inventeurs:
• **VISSIERE, David**
  **75009 Paris (FR)**
• **CHESNEAU, Charles-Ivan**
  **75008 Paris (FR)**
• **HILLION, Mathieu**
  **27200 Vernon (FR)**
• **MEIER, Hendrik**
  **27200 Vernon (FR)**
• **CARUSO, David**
  **Kirkland, WA 98033 (US)**

(74) Mandataire: **Regimbeau
20, rue de Chazelles
75847 Paris Cedex 17 (FR)**

(56) Documents cités:
**US-A- 5 134 369          US-A1- 2011 077 889
US-A1- 2014 222 409      US-A1- 2014 278 191**

• **ZHANG ZHI-QIANG: "Two-Step Calibration
Methods for Miniature Inertial and Magnetic
Sensor Units", IEEE TRANSACTIONS ON
INDUSTRIAL ELECTRONICS, IEEE SERVICE
CENTER, PISCATAWAY, NJ, USA, vol. 62, no. 6,
1 juin 2015 (2015-06-01), pages 3714-3723,
XP011580617, ISSN: 0278-0046, DOI:
10.1109/TIE.2014.2375258 [extrait le 2015-05-08]**

EP 3 658 921 B1

**Description**

DOMAINE TECHNIQUE GENERAL

La présente invention concerne le domaine des magnétomètres. Plus précisément, elle concerne un procédé de calibration d'au moins un magnétomètre.

CONTEXTE ET ARRIERE-PLAN TECHNOLOGIQUE

Le champ magnétique est un champ vectoriel en l'espèce tridimensionnel, c'est-à-dire associant un vecteur champ magnétique noté $\vec{B}$ et de dimension trois à chaque emplacement de l'espace. Le champ magnétique en un point se caractérise ainsi par sa norme et sa direction.

Un magnétomètre permet de mesurer le champ magnétique en un point. Un magnétomètre peut être un magnétomètre mono-axial, capable de mesurer une composante du champ magnétique dans une position, i.e. la projection du vecteur champ magnétique $\vec{B}$ au niveau dudit magnétomètre selon son axe. Un magnétomètre peut également êtreun magnétomètre tri-axe, capable de mesurer le champ magnétique selon ses trois axes, qui peut être constitué de trois magnétomètres mono-axe rigidement liés entre eux et orientés selon des axes différents, généralement sensiblement orthogonaux.

Toutefois, la mesure du champ magnétique par un magnétomètre n'est pas parfaite, de sorte que la mesure du champ magnétique dévie du champ magnétique réel. Par exemple, des effets de fers durs peuvent être crées par rémanence des certains composants à de forts champs magnétiques et entraîner des biais de mesure. Des facteurs d'échelle peuvent également distordre la mesure. Par ailleurs, des effets dus à la configuration physique du magnétomètre et au montage du magnétomètre peuvent également affecter la mesure.

On peut ainsi par exemple écrire la mesure d'un magnétomètre triaxe sous la forme linéaire suivante :

$$\vec{B}_m = D\vec{B} + \vec{b}$$

où $\vec{B}_m$ est la mesure du champ magnétique par le magnétomètre, $\vec{B}$ est le champ magnétique réel, D est une matrice appelée facteur d'échelle, et $\vec{b}$ est un biais de mesure. Le facteur d'échelle et le biais de mesure sont donc des paramètres de mesure qui viennent polluer la mesure du champ magnétique par rapport au champ magnétique réel. Il convient d'estimer ces paramètres afin de pouvoir corriger la mesure du champ magnétique avant de l'utiliser par ailleurs. La calibration d'un magnétomètre revient à déterminer ces paramètres et à en déduire des corrections (par inversion de la forme du modèle de mesure par exemple) à apporter aux sorties du magnétomètre afin que la mesure corrigée reflète plus fidèlement le champ magnétique réel.

Une calibration précise du magnétomètre est notamment requise pour les applications qui requièrent une grande précision. En particulier, une centrale magnéto-inertielle peut comprendre, outre des accéléromètres, un réseau de plusieurs magnétomètres disposés à des emplacements différents qui permettent l'estimation simultanée du champ et du gradient magnétique, afin de permettre de déterminer notamment une estimation du vecteur vitesse et du vecteur position lors d'une navigation. Les documents FR2914739B1 et EP2541199 présentent ainsi deux approches dites de navigation magnéto-inertielles. La précision de ces mesures est essentielle à la bonne performance de reconstruction du mouvement de la centrale magnéto-inertielle.

Par ailleurs, la position et l'orientation respectives de chacun des magnétomètres d'une telle centrale magnéto-inertielle peuvent également constituer des paramètres influençant la mesure. La calibration peut également comprendre la détermination de ces paramètres.

Plusieurs méthodes de calibration d'un magnétomètre ont été proposées. L'une de ces méthodes consiste à faire pivoter le magnétomètre dans un espace dans lequel le champ magnétique est constant et non perturbé, par exemple le champ magnétique terrestre dans un endroit exempt de perturbations, comme un champ agricole. Un magnétomètre triaxe à réponse affine placé dans le champ magnétique constant selon une orientation arbitraire voit l'espace de ses mesures brutes identifiable à une ellipse. Une transformation réciproque permet de renvoyer cet espace de mesure brutes vers un espace de mesures calibrées sphériques en identifiant les paramètres de l'ellipse ce qui donne de manière quasi directe les paramètres de calibration.

L'article de Zhi-Quiang Zhang "Two step calibration methods for miniature inertial and magnetic sensor units", IEEE Transactions on Industrial Electronics, vol.62, no.6, 1er juin 2015, pages 3714-3723, décrit ainsi un procédé de calibration d'un magnétomètre qui exploite le champ magnétique terrestre M supposé constant et non perturbé.

Cette méthode est cependant compliquée puisqu'elle nécessite de disposer d'un endroit avec un champ homogène et constant dans le temps (norme constante). Il faut aussi transporter à l'extérieur les magnétomètres à calibrer, et une manipulation individuelle de ceux-ci. De plus, cette méthode, si elle permet effectivement d'identifier les paramètres intrinsèques d'un capteur magnétique (biais, facteur d'échelle), ne permet pas d'identifier les paramètres de calibration géométrique (position relative des magnétomètres) d'un réseau de magnétomètres.

Une autre méthode consiste à disposer les magnétomètres à calibrer dans un champ magnétique imposé, par exemple généré au moyen de bobines de Helmholtz pilotées en courant de sorte que le champ magnétique généré soit homogène et de norme constante. Comme le champ magnétique est connu, en amplitude et en orientation, il suffit alors de paramétrer un modèle d'erreur des magnétomètres en comparant les sorties des magnétomètres avec le champ magnétique imposé. Toutefois, cette méthode nécessite, pour pouvoir disposer d'un champ magnétique imposé non perturbé, la mise en place d'une infrastructure complexe qui peut être onéreuse, lourde et encombrante. De plus, il se pose également la question de la précision de la connaissance du champ magnétique généré, nécessitant également une calibration de celui-ci.

La demande de brevet US 2014/222409 A1 décrit ainsi un procédé de calibration d'un magnétomètre dans le cadre d'une cartographie de champ magnétique, faisant intervenir un modèle liant la valeur d'un champ magnétique avec l'emplacement et l'orientation du magnétomètre, pour une pluralité d'emplacements et d'orientations différentes dans un volume d'intérêt au champ magnétique imposé par un générateur de champ magnétique.

## PRESENTATION DE L'INVENTION

L'invention a pour but de remédier au moins en partie à ces inconvénients et préférentiellement à tous, et vise notamment à proposer une méthode de calibration d'un magnétomètre ou d'un réseau de magnétomètres qui soit simple à mettre en œuvre et précise. Cette méthode est rendue possible par l'exploitation d'une relation reliant l'évolution du champ magnétique et le mouvement du magnétomètre.

A cet effet, il est proposé un procédé de calibration d'un magnétomètre comprenant les étapes suivantes :

- le magnétomètre parcourt un ensemble de positions de parcours, lesdites positions se distinguant entre elles par un emplacement du magnétomètre et/ou par une orientation du magnétomètre ;
- acquisition par le magnétomètre à des instants d'acquisition d'une pluralité de mesures du champ magnétique lorsque le magnétomètre parcourt ledit ensemble de positions de parcours ;
- fourniture d'informations de trajectoire représentatives de l'emplacement et de l'orientation d'un point solidaire du magnétomètre au cours du parcours de l'ensemble de positions de parcours à des instants de parcours,
- pour chacun d'une pluralité d'instants de détermination déterminés à partir des instants d'acquisition et des instants de parcours, mise en correspondance des mesures du champ magnétique avec les informations de trajectoire,
- détermination de paramètres de calibration du magnétomètre par la minimisation d'une fonction de coût faisant intervenir, pour une pluralité d'instants de détermination, au moins lesdits paramètres de calibration, une mesure du champ magnétique, et une relation liant l'évolution d'un champ magnétique avec l'évolution de l'emplacement et de l'orientation du magnétomètre dérivée des informations de trajectoire, la relation liant l'évolution d'un champ magnétique avec l'évolution de l'emplacement et de l'orientation du magnétomètre traduisant localement une équation de la dérivée particulaire du champ magnétique :

$$\dot{\vec{B}} = \nabla \vec{B}.\vec{v} + \Omega \times \vec{B}$$

avec $\vec{B}$ un vecteur champ magnétique, $\nabla \vec{B}$ un vecteur gradient du champ magnétique, $\dot{\vec{B}}$ un vecteur de la dérivée temporelle du champ magnétique, $\vec{v}$ un vecteur vitesse représentatif de la modification de l'emplacement et $\Omega$ une matrice de rotation représentative de la modification de l'orientation.

Le procédé propose ainsi, à partir d'informations sur le mouvement du magnétomètre, de déduire les paramètres de calibration du magnétomètre qui permettent de mesurer ensuite précisément le champ magnétique, et éventuellement le gradient de champ magnétique.

Le procédé est avantageusement complété par les caractéristiques suivantes, prises seules ou en quelconque de leurs combinaisons techniquement possibles :

- la fonction de coût fait intervenir des termes d'erreur concernant l'évolution de l'emplacement et de l'orientation du magnétomètre dérivée des informations de trajectoire ;
- la fonction de coût fait intervenir des termes d'erreur concernant de mesures capteurs, lesdits mesures capteurs pris seuls permettant d'obtenir les informations de trajectoire, les informations de trajectoire étant alors déterminées en même temps que les paramètres de calibration ;

- la minimisation de la fonction de coût est effectuée avec un observateur d'état ;
- la fonction de coût est basée sur des comparaisons entre une estimation théorique de la mesure du champ magnétique à un instant de détermination et une mesure du champ magnétique audit instant de détermination, l'estimation théorique du champ magnétique prenant en compte les paramètres de calibration ;
- l'estimation théorique de la mesure du champ magnétique est déterminée à partir de la relation liant l'évolution d'un champ magnétique avec l'évolution de l'emplacement et de l'orientation du magnétomètre dérivée des informations de trajectoire ;
- l'estimation théorique de la mesure du champ magnétique est déterminée au moins à partir :

  - d'une mesure du champ magnétique à un instant de détermination précédent,
  - de l'évolution de l'emplacement et de l'orientation d'un point solidaire du magnétomètre entre l'instant de détermination et l'instant de détermination précédent, déterminées à partir des informations de trajectoire,
  - des paramètres de calibration ;

- le procédé comprend également une acquisition à des instants d'acquisition d'une pluralité de mesures d'un gradient du champ magnétique lorsque le magnétomètre parcourt ledit ensemble de positions de parcours, et l'estimation théorique du champ magnétique est également déterminée à partir d'une mesure du gradient du champ magnétique à l'instant de détermination précédent ;
- l'estimation théorique de la mesure du champ magnétique à un instant de détermination est déterminée à partir :

  - d'une grandeur du champ magnétique en un point de référence,
  - d'un gradient du champ magnétique audit point de référence, et
  - de la différence entre l'emplacement du point solidaire du magnétomètre et un emplacement du point de référence,
  - de la rotation entre l'orientation du point solidaire du magnétomètre et une orientation au point de référence,

  la grandeur du champ magnétique en un point de référence et le gradient du champ magnétique audit point de référence étant déterminé par la minimisation de la fonction de coût ;
- les paramètres de calibration comprennent :

  - un premier biais magnétométrique affectant la mesure du champ magnétique, et/ou
  - un second biais magnétométrique affectant une mesure d'un gradient du champ magnétique, et/ou
  - un paramètre d'échelle affectant une amplitude de la mesure du champ magnétique et/ou
  - des paramètres de configuration spatiale du magnétomètre ;

- la mise en correspondance consiste à interpoler au moins un ensemble parmi :

  - un ensemble des mesures du champ magnétique et du gradient de champ magnétique,
  - un ensemble des informations de trajectoire,

  de sorte qu'à chaque instant de détermination corresponde au moins une mesure du champ magnétique et des informations de trajectoire ;
- les informations de trajectoire sont fournies par l'utilisation d'un imageur repérant l'emplacement et l'orientation du magnétomètre à chaque instant de parcours lorsque le magnétomètre parcourt le premier ensemble de position ;
- l'imageur est solidaire du magnétomètre, et une mire fixe est disposée dans un champ de vision dudit imageur, les informations de trajectoire étant dérivées du repérage de la mire dans des images acquises par l'imageur lorsque le magnétomètre parcourt l'ensemble de positions de parcours ;
- un dispositif de déplacement mécanique déplace le magnétomètre d'une position à une autre position dans le premier ensemble de position lorsque le magnétomètre parcourt ledit ensemble de positions de parcours, les informations de trajectoire étant dérivées de mesures de positions dudit dispositif de déplacement mécanique ou de consignes de positions dudit dispositif de déplacement mécanique ;
- le magnétomètre est solidaire de capteurs inertiels configurés pour déterminer à chacun des instants de parcours des accélérations et des vitesses angulaires, et les informations de trajectoires sont dérivées desdites accélérations et des vitesses angulaires ;
- le magnétomètre est disposé dans une centrale magnéto-inertielle.

L'invention concerne également une unité de traitement automatisé de données comprenant un processeur, une mémoire et des interfaces d'entrée et de sortie, configurée pour mettre en œuvre le procédé selon l'invention, et notamment pour :

- recevoir une pluralité de mesures du champ magnétique acquises à des instants d'acquisition par un magnétomètre parcourant un ensemble de positions de parcours, lesdites se distinguant entre elles par l'emplacement spatial du magnétomètre et/ou par l'orientation du magnétomètre ;
- recevoir des informations de trajectoire représentatives de l'emplacement et de l'orientation d'un point solidaire du magnétomètre au cours du parcours des positions de l'ensemble de positions de parcours à des instants de parcours,
- pour chacun d'une pluralité d'instants de détermination déterminés à partir des instants d'acquisition et des instants de parcours, mettre en correspondance des mesures du champ magnétique et du gradient de champ magnétique avec les informations de trajectoire,
- déterminer des paramètres de calibration du magnétomètre par la minimisation d'une fonction de coût faisant intervenir, pour une pluralité d'instants de détermination, au moins lesdits paramètres de calibration, une mesure du champ magnétique, et une relation liant l'évolution d'un champ magnétique avec l'évolution de l'emplacement et de l'orientation du magnétomètre dérivée des informations de trajectoire, la relation liant l'évolution d'un champ magnétique avec l'évolution de l'emplacement et de l'orientation du magnétomètre traduisant localement une équation de la dérivée particulaire du champ magnétique :

$$\dot{\vec{B}} = \nabla \vec{B} . \vec{v} + \Omega \times \vec{B}$$

avec $\vec{B}$ un vecteur champ magnétique, $\nabla\vec{B}$ un vecteur gradient du champ magnétique, $\dot{\vec{B}}$ un vecteur de la dérivée temporelle du champ magnétique, $\vec{v}$ un vecteur vitesse représentatif de la modification de l'emplacement et $\Omega$ une matrice de rotation représentative de la modification de l'orientation.

L'invention concerne également un produit programme d'ordinateur comprenant des instructions de code de programme enregistrées sur un support non-volatile lisible par un ordinateur pour l'exécution des étapes du procédé selon l'invention lorsque lesdites instructions de code programme sont exécutées sur un ordinateur.

PRESENTATION DES FIGURES

L'invention sera mieux comprise, grâce à la description ci-après, qui se rapporte à des modes de réalisations et des variantes selon la présente invention, donnés à titre d'exemples non limitatifs et expliqués avec référence aux dessins schématiques annexés, dans lesquels:

- la figure 1 est un schéma illustrant un exemple d'équipement comprenant des magnétomètres à calibrer,
- la figure 2 est un schéma illustrant une possible configuration pour la mise en œuvre du procédé de calibration selon un mode de réalisation possible de l'invention,

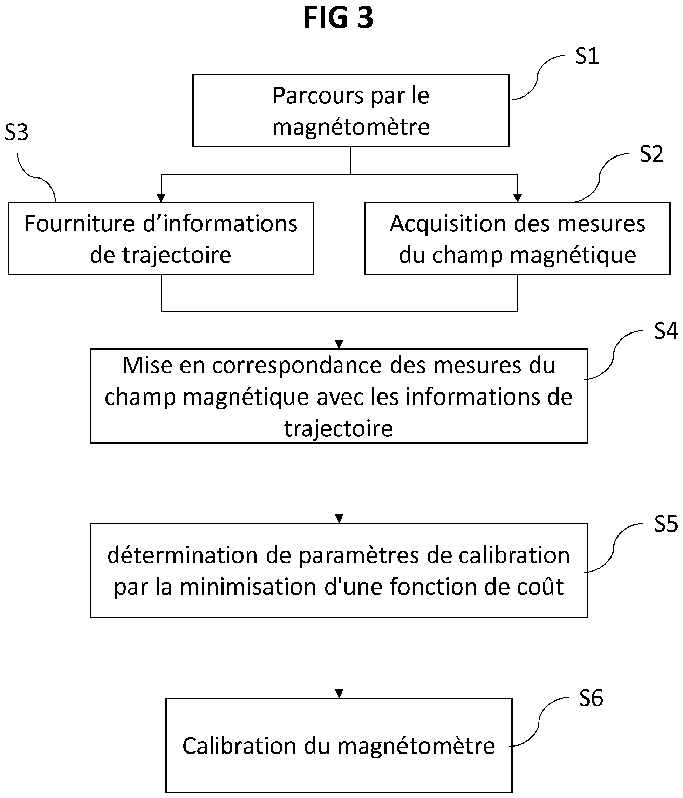

- la figure 3 est un diagramme schématique montrant des étapes du procédé de calibration selon un mode de réalisation possible de l'invention.

DESCRIPTION DETAILLEE

On entend par position la combinaison d'un emplacement et d'une orientation, ce qui permet de décrire complètement la configuration spatiale d'un objet. Dans une écriture vectorielle d'un espace à trois dimensions, l'emplacement est défini par un vecteur à trois composantes (les coordonnées spatiales dans un repère), et l'orientation est également définie par un vecteur à trois composantes (les angles de rotation par rapport au repère).

On entend par "informations de trajectoire" des données représentatives de la position d'un point solidaire du magnétomètre au cours du temps lorsque le magnétomètre parcourt l'ensemble des positions de parcours. La position d'un point solidaire du magnétomètre peut notamment être celle d'un solide rigidement lié au magnétomètre. Ces données peuvent être chronologiquement ordonnées selon des instants de parcours correspondant à chaque position de parcours. Ces données peuvent par exemple être des emplacements et des orientations ou des dérivées par rapport au temps de ceux-ci comme notamment des vitesses ou accélérations, des vitesses angulaires ou des accélérations angulaires.

Une unité de traitement automatisé de données, comme par exemple un ordinateur, comprenant au moins un processeur et une mémoire, est configurée pour mettre en œuvre le procédé. L'unité de traitement automatisé de données est également configurée pour recevoir au moins des mesures du champ magnétique en provenance du magnétomètre. De préférence, l'unité de traitement automatisé de données est configurée pour recevoir également des mesures d'un gradient du champ magnétique.

Dans la présente description, le magnétomètre à calibrer est un magnétomètre triaxe capable de mesurer le champ magnétique selon ses trois axes. Le magnétomètre peut faire partie d'un réseau de magnétomètres solidairement liés à un même capteur, comme par exemple dans le cas d'une centrale magnéto-inertielle, auquel cas le réseau de magnétomètres permet également de mesurer un gradient du champ magnétique dans le référentiel du capteur.

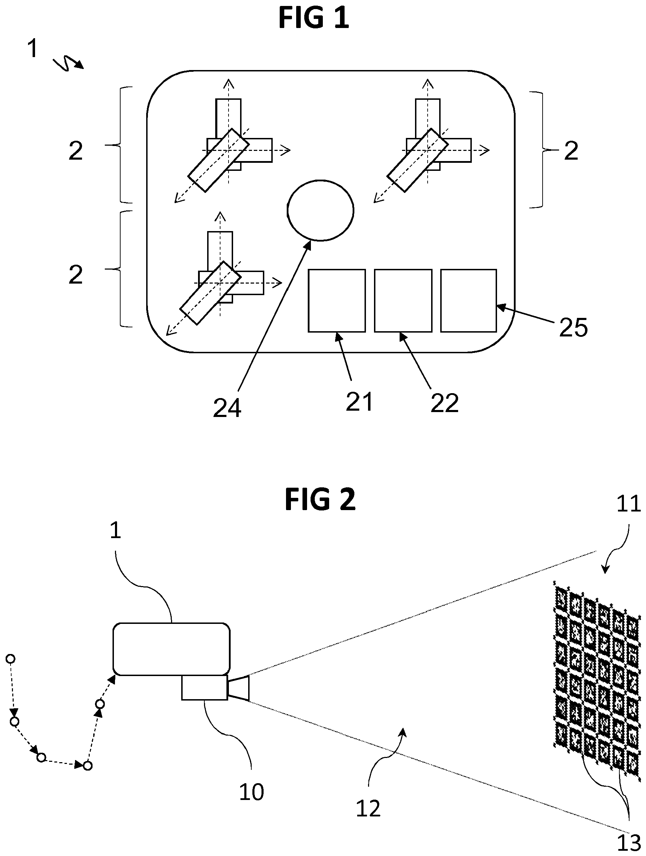

A titre illustratif, la figure 1 montre un exemple d'un réseau de magnétomètre 2 équipant une centrale magnéto-inertielle 1. Les magnétomètres 2 sont ici des magnétomètres tri-axes, constitués chacun de trois magnétomètres mono-axe orientés selon des axes sensiblement perpendiculaires entre eux. La centrale magnéto-inertielle 1 comprend au moins huit magnétomètres mono-axe, et typiquement neuf magnétomètres mono-axe organisés en trois magnétomètres 2 tri-axes, comme représenté sur la figure 1. Les magnétomètres 2 sont solidaires de la centrale magnéto-inertielle 1, i.e. ils présentent un mouvement sensiblement identique dans le référentiel terrestre. La centrale magnéto-inertielle 1 comprend également des capteurs inertiels tels que des accéléromètres et des gyromètres 24, généralement trois accéléromètres et trois gyromètres disposés en tri-axe. La centrale magnéto-inertielle 1 comprend également des moyens de traitement 21 (typiquement un processeur), des moyens de stockage de données 22, et des moyens de communication 25 vers un dispositif extérieur.

Dans le cadre du procédé de calibration, le magnétomètre 2 parcourt (étape S1) un ensemble de positions de parcours, lesdites positions de parcours se distinguant entre elles par un emplacement du magnétomètre 2 et/ou par une orientation du magnétomètre 2. Contrairement aux procédés de l'état de la technique, il n'y pas de contraintes d'homogénéité ou de constance du champ magnétique dans lequel se déroule le parcours du magnétomètre 2. Il n'est donc pas nécessaire de disposer d'un champ magnétique imposé ou non perturbé. De préférence, l'ensemble des positions de parcours n'est pas défini a priori, il résulte du déplacement du magnétomètre 2 lors de son parcours. Les positions de parcours sont simplement les positions prises par le magnétomètre 2 lors de son parcours.

Pour effectuer ce parcours, le magnétomètre 2 peut simplement être manipulé manuellement par un opérateur. On peut également prévoir un dispositif de déplacement mécanique qui déplace le magnétomètre 2 d'une position de parcours à une autre position de parcours. Par exemple, ce dispositif de déplacement mécanique peut être un bras robotisé, un tapis roulant, ou tout autre dispositif permettant de faire varier l'emplacement et l'orientation du magnétomètre 2.

Lors de son parcours, le magnétomètre 2 acquiert à des instants d'acquisition une pluralité de mesures du champ magnétique (étape S2). Ainsi, pour chaque instant d'acquisition, le magnétomètre 2 acquiert une mesure $\vec{B}_m$ du champ magnétique, qui dépend de l'emplacement du magnétomètre 2 et de son orientation. Il est possible de filtrer les mesures du magnétomètre pour compenser certaines non-stationnarités du champ magnétique. Par exemple, les courants électriques des installations électriques peuvent perturber le champ magnétique. Un filtrage (par exemple coupe-bande) à 50 Hz ou 60 Hz permet de limiter ces perturbations. De même, le champ magnétique généré par le système de positionnement ou de mesure de position peut être, s'il est connu, retiré de la mesure du magnétomètre.

Des informations de trajectoire représentatives de l'emplacement et de l'orientation d'un point solidaire du magnétomètre 2 au cours du parcours à des instants de parcours sont fournies (étape S3). Il n'est pas nécessaire que ces informations de trajectoires reflètent l'emplacement absolu ou l'orientation absolue du magnétomètre 2, par exemple par rapport à un référentiel du champ magnétique qui serait typiquement le référentiel terrestre. En effet, le procédé proposé exploite l'évolution d'un champ magnétique avec l'évolution de l'emplacement et de l'orientation du magnétomètre 2, et non pas la connaissance du champ magnétique en tout point de la trajectoire du magnétomètre 2. Il suffit donc de connaître l'emplacement et l'orientation d'un point solidaire du magnétomètre 2 au cours du parcours.

Utiliser un point solidaire du magnétomètre plutôt que le magnétomètre 2 en lui-même présente de nombreux avantages. Tout d'abord, il est souvent plus aisé de repérer l'emplacement et l'orientation d'un point solidaire du magnétomètre 2 que du magnétomètre lui-même. Par exemple, lorsqu'une mire et un imageur sont utilisés, c'est la mire ou l'imageur qui sera solidaire du magnétomètre 2 et dont l'emplacement et l'orientation seront déterminés. Ensuite, lorsque plusieurs magnétomètres 2 sont organisés en réseau solidaires les uns des autres, comme c'est typiquement le cas d'une centrale magnéto-inertielle 1, cela permet de pouvoir procéder à la calibration de tous les magnétomètres 2 du réseau avec les mêmes informations de trajectoire. Outre une simplicité et un gain de temps non négligeable, cela permet également d'harmoniser la calibration des magnétomètres 2 entre eux.

Ces informations de trajectoires peuvent être obtenues de différentes façons. Les informations de trajectoire peuvent être fournies par l'utilisation d'un imageur repérant l'emplacement et l'orientation du magnétomètre à chaque instant de parcours lorsque le magnétomètre 2 parcourt les positions de parcours.

Il est possible par exemple de fixer rigidement un imageur avec le magnétomètre 2 et de déterminer les informations de trajectoire à partir du traitement des images acquises par l'imageur lors du déplacement de l'ensemble formé par le magnétomètre 2 et l'imageur. On peut par exemple mettre en œuvre un procédé de localisation et cartographie simultanées (plus connu sous l'acronyme SLAM pour l'anglais "simultaneous localization and mapping"), exploitant une stéréovision de l'imageur, une caméra de profondeur additionnelle ou des capteurs inertiels. En particulier, dans le cas d'un imageur attaché à une centrale magnéto-inertielle 1 incorporant le magnétomètre 2, il est possible d'utiliser le triplet imageur/accéléromètre/gyromètre pour déterminer les informations de trajectoire, à l'aide de la technique SLAM ou d'une technique d'odométrie vision/inertiel.

On peut également utiliser une mire ou des points de repère dont les positions sont connues. Par exemple, l'imageur peut être solidaire du magnétomètre 2 et une mire fixe disposée dans un champ de vision dudit imageur. Les informations de trajectoire sont alors dérivées du repérage de la mire dans des images acquises par l'imageur lorsque le magnétomètre 2 parcourt l'ensemble de positions de parcours. Enfin, l'imageur peut être fixe dans l'environnement et des mires optiques fixées au système (par exemple salle de motion capture).

La figure 2 montre ainsi un exemple de configuration utilisant une mire lorsque le magnétomètre 2 se déplace d'une position de parcours à une autre. L'imageur 10 est ici une caméra solidaire de la centrale inertielle 1 incorporant le magnétomètre 2. Une mire 11 est fixe dans un référentiel extérieur (typiquement le référentiel terrestre) et disposée dans le champ de vision 12 de l'imageur 11. Dans cet exemple, la mire 11 comprend plusieurs blocs 13 régulièrement répartis présentant chacun un motif distinct, de sorte que chaque bloc est identifiable. Si besoin, l'imageur 10 peut préalablement être calibré en plaçant la mire devant l'imageur à différents emplacements et selon différentes orientations afin d'obtenir une série d'images montrant la mire 11 sous différentes configurations spatiales. Un traitement des images détecte dans chacune d'elles la position de la projection des points particuliers de la mire 11. Cette position détectée est ensuite utilisée (par exemple par des méthodes d'optimisation non-linéaires) pour déterminer les paramètres intrinsèques de l'imageur 10, tels que les paramètres de distance focale et de distorsion ainsi que la position du centre optique requis pour l'expression d'une fonction de projection/déprojection pour le système optique de l'imageur. La mire 11 de cet exemple est une mire plane, qui a la particularité d'être facile à produire puisqu'elle peut être simplement imprimée sur une feuille de papier. Il est également possible d'utiliser des mires 11 en trois dimensions, plus difficile à produire mais rendant plus facile et plus précise la calibration.

La mire 11 étant fixe, un opérateur déplace l'ensemble formé par l'imageur 10 et par le magnétomètre 1 en veillant à garder la mire 11 dans le champ de vision 12 de l'imageur 10. Les mouvements de déplacements peuvent être faits aléatoirement ou selon un parcours pré-établi. L'imageur 10 acquiert des images lors de ce déplacement. La position de la mire 11 est ensuite détecté dans chaque image. La position relative de l'imageur 10 par rapport à la mire 11 fixe est alors calculée par un algorithme de vision par ordinateur pour chaque image, permettant de déterminer la position de l'imageur 10 dans le référentiel attaché à la mire 11 aux instants du parcours correspondant aux instants de prise de vue de l'imageur 10. L'imageur 10 étant solidaire du magnétomètre 2, on obtient ainsi des informations de trajectoire représentatives de l'emplacement et de l'orientation d'un point solidaire du magnétomètre 2 au cours du parcours.

Il est bien entendu qu'il est également possible d'utiliser un imageur 10 fixe et une mire 11 solidaire du magnétomètre 2. On peut également employer plusieurs mires 11 afin de permettre une plus grande liberté de mouvement. Il est également possible de se passer de la mire 11 si le repérage de l'emplacement et de l'orientation du magnétomètre dans les images peut être fait directement à partir des images de l'ensemble intégrant le magnétomètre 2. On peut également prévoir une configuration de capture de mouvement ("motion capture" en anglais) où plusieurs cibles optiques sont disposées solidairement au magnétomètre 2.

D'autres méthodes permettent d'obtenir ces informations de trajectoire. Par exemple, dans le cas déjà évoqué où un dispositif de déplacement mécanique déplace le magnétomètre 2 d'une position de parcours à une autre position de parcours, les informations de trajectoire peuvent être dérivées de mesures de positions ou de consignes de positions dudit dispositif de déplacement mécanique. L'utilisation d'un bras robotisé permet notamment d'avoir directement des données sur l'emplacement dans l'espace et sur l'orientation de l'extrémité du bras robotisé, qui est un point solidaire du magnétomètre 2 qu'il porte.

On peut encore exploiter un éventuel système de radionavigation, par exemple avec un récepteur solidaire du magnétomètre 2 qui reçoit des ondes émises par plusieurs stations. La position du récepteur est ensuite déterminée par un procédé de triangulation, fusionnant les positions relatives par rapport à chaque station émettrice. Ainsi, toute méthode permettant de fournir des informations de trajectoire représentatives de l'emplacement et de l'orientation d'un point solidaire du magnétomètre 2 au cours du parcours peut être employée. On peut également combiner plusieurs méthodes.

Dans le cas d'un magnétomètre 2 intégré à une centrale magnéto-inertielle 1, il est également possible de comparer les mesures des accéléromètres et des gyromètres avec les informations de trajectoire pour pouvoir calibrer les accéléromètres et gyromètres 24, et notamment en éliminer les biais. On peut d'ailleurs également obtenir les informations de trajectoire à partir de ces mesures des accéléromètres et des gyromètres 24. On peut même alors calibrer simultanément les magnétomètres 2, les accéléromètres et les gyromètres 24, en intégrant les différents biais dans la fonction de coût qui sera décrite plus loin.

Le procédé de calibration repose sur l'exploitation de mesures du champ magnétique, acquises à des instants d'acquisition, synchrones d'informations de trajectoires à des instants de parcours. Or, ces deux types de données proviennent d'origines différentes, et les instants d'acquisition ne correspondent généralement pas aux instants de parcours. Une mise en correspondance (étape S4) est donc requise entre les mesures du champ magnétique et les informations de trajectoire. Cette mise en correspondance vise à associer et synchroniser des mesures du champ magnétique et des informations de trajectoire, afin de pouvoir disposer, pour chacun d'une pluralité d'instants de détermination, une mesure du champ magnétique et des informations de trajectoire représentatives de l'emplacement et de l'orientation d'un point solidaire du magnétomètre 2 à cet instant de détermination.

A cette fin, la mise en correspondance peut comprendre l'interpolation d'au moins un ensemble ou sous-ensemble parmi :

- un ensemble des mesures du champ magnétique et du gradient de champ magnétique,
- un ensemble des informations de trajectoire.

Par exemple, il peut n'être nécessaire que d'interpoler les informations de trajectoire, car celles-ci présentent généralement une fréquence moins élevée que les mesures du champ magnétique. En effet, un magnétomètre 2 peut aisément acquérir des mesures du champ magnétique à une fréquence de 200 Hz, alors que les informations de trajectoire peuvent être plus parcellaires, en particulier lorsqu'un imageur 10 est utilisé. Toutefois, il est possible également que ce soit l'inverse. Il est à noter que dans le cas où les instants d'acquisition correspondraient aux instants de parcours, la mise en correspondance se borne à associer les mesures du champ magnétique avec les informations de trajectoire aux mêmes instants, qui deviendraient alors des instants de détermination.

Pour interpoler un ensemble, on utilise de préférence des splines temporelles, mais d'autres approches peuvent être adoptées, comme par exemple une représentation discrète de la trajectoire parcourue par le magnétomètre 2. La représentation en spline permet notamment de forcer la continuité de la trajectoire. De préférence, les splines utilisées pour l'interpolation sont dérivables au moins deux fois. Par exemple, on peut interpoler les emplacements et les orientations du point solidaire du magnétomètre. La représentation en spline permet également d'optimiser les différents paramètres intervenants, en particulier les paramètres de synchronisation temporelle, à l'aide d'une méthode basée sur le gradient d'un critère à minimiser.

Par exemple, lorsque des capteurs inertiels sont solidaires du magnétomètre 2, comme dans le cas d'une centrale magnéto-inertielle 1, on peut alors, en dérivant les splines, calibrer les mesures d'accélérations ou de rotation de ces capteurs. En effet, la dérivée de la spline d'orientation à chaque pas de temps doit être cohérente avec la mesure débiaisée et harmonisée du gyromètre. De même, la dérivée seconde de la spline d'emplacement à chaque pas de temps doit être cohérente avec la mesure débiaisée et harmonisée des accéléromètres ainsi qu'avec la valeur estimée de la gravité.

Différents paramètres tels que les coefficients des splines, les biais inertiels, la désynchronisation des capteurs inertiels, et la direction de la gravité dans le référentiel de la mire, la différence de position entre l'imageur 10 et le point de percussion de l'accéléromètre, peuvent être optimisés pour minimiser une fonction de coût multicritère comprenant des termes d'erreur gyrométrique, des termes d'erreur accélérométrique. Ces termes d'erreur sont par exemple exprimés aux moindres carrés. Lorsqu'un imageur 10 et une mire 11 sont utilisés, il est également possible de prendre en compte dans la fonction de coût un critère de reprojection basé sur la comparaison entre la projection théorique de points particuliers de la mire et leurs positions dans les images acquises par l'imageur 10.

Grâce à la mise en correspondance, on peut définir une pluralité d'instants de détermination pour chacun desquels on dispose d'une mesure du champ magnétique et d'informations de trajectoire représentatives de l'emplacement et de l'orientation d'un point solidaire du magnétomètre à cet instant de trajectoire. Les instants de détermination sont donc déterminés à partir des instants d'acquisition et des instants de parcours, puisque ce sont eux qui déterminent la disponibilité des mesures du champ magnétique et des informations de trajectoire, ou éventuellement leur interpolation. De façon similaire, on peut également disposer pour chaque instant de détermination d'une mesure du gradient magnétique si cette mesure est disponible.

De préférence, les instants de détermination sont choisis suffisamment proches pour éviter que le champ magnétique ne varie trop entre les positions occupées par le magnétomètre 2 entre deux instants de détermination consécutifs. En particulier, lorsque le gradient du champ magnétique est utilisé, les instants de détermination sont de préférence suffisamment rapprochés pour pouvoir considérer le gradient du champ magnétique comme localement uniforme entre les positions occupées par le magnétomètre entre deux instants de détermination consécutifs. Par exemple, les instants de détermination sont espacés d'une durée inférieure ou égale à 1s, de préférence inférieure ou égale à 10ms, et de préférence encore inférieure ou égale à 5 ms. De même, le magnétomètre 2 acquiert de préférence les mesures à une fréquence suffisante pour pouvoir rendre compte correctement du mouvement du magnétomètre. De préférence, le magnétomètre 2 acquiert les mesures à une fréquence supérieure à 100 Hz, comme par exemple 200 Hz. Toutefois, ces deux préférences ne sont pas toujours utiles. En particulier, lorsque le procédé utilise une formulation intégrale, c'est-à-dire qu'on utilise uniquement un modèle du champ en tant que relation liant l'évolution d'un champ magnétique avec l'évolution de l'emplacement et de l'orientation du magnétomètre comme décrit par la suite, les instants de parcours, d'acquisition ou de détermination peuvent être d'un éloignement quelconque.

Pour déterminer les paramètres de calibration du magnétomètre 2 (étape S5), le procédé passe par la minimisation d'une fonction de coût faisant intervenir, pour une pluralité d'instants de détermination, au moins lesdits paramètres de calibration, une mesure du champ magnétique, et une relation liant l'évolution d'un champ magnétique avec l'évolution de l'emplacement et de l'orientation du magnétomètre 2 dérivée des informations de trajectoire.

De préférence, la fonction de coût est basée sur des comparaisons entre une estimation théorique du champ magnétique à un instant de détermination et une mesure du champ magnétique audit instant de détermination, l'estimation théorique du champ magnétique prenant en compte les paramètres de calibration. Typiquement, l'estimation théorique du champ magnétique est déterminée à partir de la relation liant l'évolution d'un champ magnétique avec l'évolution de l'emplacement et de l'orientation du magnétomètre 2 dérivée des informations de trajectoire.

L'estimation théorique du champ magnétique peut être déterminée au moins à partir :

- d'une mesure du champ magnétique à un instant de détermination précédent,
- de l'évolution de l'emplacement et de l'orientation d'un point solidaire du magnétomètre 2 entre l'instant de détermination et l'instant de détermination précédent, déterminées à partir des informations de trajectoire,
- des paramètres de calibration.

De préférence, l'estimation théorique du champ magnétique est également déterminée à partir d'une mesure du gradient du champ magnétique à l'instant de détermination précédent.

A titre d'exemple, la relation liant l'évolution d'un champ magnétique avec l'évolution de l'emplacement et de l'orientation du magnétomètre 2 dérivée des informations de trajectoire peut être une traduction locale de l'équation de la dérivée particulaire du champ magnétique :

$$\dot{\vec{B}} = \nabla\vec{B}.\vec{v} + \Omega.\vec{B} \qquad (1)$$

avec $\vec{B}$ un vecteur champ magnétique, $\nabla\vec{B}$ un vecteur gradient du champ magnétique, $\dot{\vec{B}}$ un vecteur de la dérivée temporelle du champ magnétique, $\vec{v}$ un vecteur vitesse représentatif de la modification de l'emplacement et $\Omega$ une matrice de rotation représentative de la vitesse de rotation, et donc de la modification de l'orientation. Par la suite, la notation de la flèche surmontant les vecteurs sera omise, mais il est bien entendu que les champs, mesures, emplacements, orientations et biais sont des vecteurs. On peut bien sûr utiliser d'autres relations liant l'évolution d'un champ magnétique avec l'évolution de l'emplacement et de l'orientation du magnétomètre, comme par exemple utiliser dérivée de l'équation (1), de la forme $\nabla_n\dot{B} = f_n(\Omega).\nabla_n B + g_n(\nabla_{n+1}B).V$, où $\nabla_n B$ est une dérivée n-ième du champ magnétique, et $f_n$ et $g_n$ des fonctions prédéterminées, comme exposé dans la demande FR1756675.

Concrètement, cette équation de la dérivée particulaire du champ magnétique est intégrée entre deux instants de détermination $t_k$ et $t_{k+1}$ par :

$$B(t_{k+1}) = \hat{R}^T(t_{k+1})\left(\hat{R}(t_k)B(t_k) + \hat{R}(t_k)\,\nabla B(t_k)\hat{R}^T(t_k)(\hat{p}(t_{k+1}) - \hat{p}(t_k))\right) \quad (2)$$

avec $B(t_{k+1})$ le champ magnétique à l'instant de détermination $t_{k+1}$ qu'on note par la suite $B_{k+1}$, $B(t_k)$ le champ magnétique à l'instant de détermination précédent $t_k$ qu'on note par la suite $B_k$, $\nabla B(t_k)$ le gradient du champ magnétique à l'instant de détermination précédent $t_k$ noté par la suite $\nabla B_k$, $\hat{R}(t_{k+1})$ représente l'orientation du magnétomètre 2 à l'instant de détermination $t_{k+1}$ qu'on note par la suite $\hat{R}_{k+1}$, $\hat{R}(t_k)$ représente l'orientation du magnétomètre 2 à l'instant de détermination précédent $t_k$ qu'on note par la suite $\hat{R}_k$, $\hat{p}(t_{k+1})$ représente l'emplacement du magnétomètre 2 à l'instant de détermination $t_{k+1}$ noté par la suite $\hat{p}_{k+1}$, $\hat{p}(t_k)$ représente l'emplacement du magnétomètre 2 à l'instant de détermination précédent $t_k$ noté par la suite $\hat{p}_k$ En simplifiant les notations, l'équation (2) devient :

$$B_{k+1} = \hat{R}_{k+1}^T\left(\hat{R}_k B_k + \hat{R}_k\,\nabla B_k\hat{R}_k^T(\hat{p}_{k+1} - \hat{p}_k)\right) \qquad (3)$$

L'emplacement $\hat{p}(t)$ et l'orientation $\hat{R}(t)$ sont dérivés des informations de trajectoire fournies précédemment. Elles peuvent directement correspondre à ces informations de trajectoire, ou bien être obtenues par calcul à partir de celle-ci, par exemple en les intégrant ou en les dérivant. Il est également possible que l'emplacement ou la localisation soient calculés en même temps que les paramètres de calibration. Il est ainsi possible de combiner dans une même fonction de coût les termes d'erreurs relevant de la calibration magnétique avec les termes d'erreur relevant d'autres mesures, dites mesures capteurs, qui, pris seuls, permettent de déterminer les informations de trajectoire (par exemple la projection des mires ou d'amers visuels dans l'/les imageur(s) ou d'autre référence). Dans ce cas, l'estimation en position n'est pas une sortie intermédiaire mais une variable interne de l'algorithme d'optimisation, et il n'y a pas de distinction entre « calcul de la localisation » et « calibration magnétique », l'algorithme résolvant les deux problèmes en minimisant une seule et unique fonction de coût. C'est en particulier le cas lorsque les informations de trajectoire peuvent être issues d'une fonction de coût minimisée, par exemple dans le cas d'une erreur de reprojection d'un point physique sur un/des imageur(s) (devant une mire, lors du SLAM, ou dans une salle de motion capture). Cette possibilité s'applique à tous les modes de réalisation, et à toutes les informations de trajectoire, et notamment, outre l'emplacement et l'orientation, les dérivées de ceux-ci.

On peut d'ailleurs réécrire l'équation (3) en fonction des modifications de l'emplacement et de l'orientation. En notant $\hat{R}_k^{k+1}$ l'orientation relative à l'instant de détermination $t_{k+1}$ par rapport à l'orientation à l'instant de détermination précédent $t_k$, c'est-à-dire l'évolution de l'orientation entre l'instant de détermination précédent $t_k$ et l'instant de détermination $t_{k+1}$, et en notant $_k\widehat{\delta p}_{k+1}$ l'emplacement du magnétomètre à l'instant de détermination $t_{k+1}$ dans le repère défini par l'emplacement du magnétomètre à l'instant de détermination précédent $t_k$, on obtient :

$$B_{k+1} = \left( \hat{R}_k^{k+1} B_k + \hat{R}_k^{k+1} \nabla B_k \, {}_k\widehat{\delta p}_{k+1} \right) \; (4)$$

Cette relation fondamentale devrait être vérifiée localement par les mesures du magnétomètre 2 si celui-ci était bien calibré. L'existence des différents paramètres à calibrer a donc pour conséquence de faire naître des écarts entre la mesure du champ magnétique et une estimation théorique du champ magnétique basée sur cette relation. C'est en cherchant à minimiser les écarts apparaissant lors de l'application de cette relation qu'on peut déterminer les valeurs des paramètres de calibration. Pour cela, on construit une fonction de coût à minimiser. Pour une pluralité d'instants de détermination, on exprime la relation formulée par l'équation (3) ou l'équation (4) en y incorporant les paramètres à calibrer entachant la mesure du champ magnétique par le magnétomètre 2.

Par exemple, si, pour simplifier, on ne s'intéresse qu'à la compensation des biais magnétiques causés par les effets de fers durs, la mesure du champ magnétique un instant de détermination $t_k$ et le gradient du champ magnétique peuvent s'écrire :

$$B_k = Bm_k - B_b \qquad (5)$$

$$\nabla B_k = \nabla Bm_k - v2g(H_b) \qquad (6)$$

Avec $Bm_k$ la mesure du champ magnétique pour l'instant de détermination $t_k$, $B_b$ le biais magnétométrique affectant la mesure du champ magnétique, $\nabla Bm_k$ le gradient mesuré du champ magnétique pour l'instant de détermination $t_k$, et $v2g(H_b)$ le biais magnétométrique affectant la mesure du gradient du champ magnétique. Les biais magnétométriques sont donc paramétrés par le vecteur $B_b$ de dimension 3 et le vecteur $H_b$ de dimension 5, avec $v2g$ une fonction de transformation de vecteur vers gradient telle que :

$$v2g\left( \begin{bmatrix} a \\ b \\ c \\ d \\ e \end{bmatrix} \right) = \begin{bmatrix} a & b & c \\ b & d & e \\ c & e & -a-d \end{bmatrix} \quad (7)$$

En remplaçant dans l'équation (3) les expressions du champ magnétique $B_k$ et du gradient du champ magnétique $\nabla B_k$ exprimées en (5) et (6), on peut obtenir un critère à minimiser basé sur une comparaison entre une estimation théorique du champ magnétique, issue de l'exploitation de la relation évoquée, et au moins une mesure du champ magnétique :

$$Bm_{k+1} - B_b = \hat{R}_{k+1}^T \left( \hat{R}_k(Bm_k - B_b) + \hat{R}_k \left( \nabla Bm_k - v2g(H_b) \right) \hat{R}_k^T (\hat{p}_{k+1} - \hat{p}_k) \right) \qquad (8)$$

La fonction de coût peut être construite en additionnant une norme $\rho$ de ce critère pour une pluralité d'instants de détermination $t_k$ :

$$\min_{B_b,H_b} \sum_{k=0}^{N} \rho \left( B_{k+1} - B_b - \hat{R}_{k+1}^T \left( \hat{R}_k(B_k - B_b) + \hat{R}_k \left( \nabla B_k - v2g(H_b) \right) \hat{R}_k^T (\hat{p}_{k+1} - \hat{p}_k) \right) \right) \qquad (9)$$

La norme $\rho$ utilisée peut par exemple être la norme L2 (racine carrée des modules des composants), ou la norme L1 (la somme des modules des composants) plus robuste, ou bien tout autre norme robuste utilisée dans les M-estimateurs (par exemple Huber, Cauchy ou Tukey). La somme peut ne pas contenir tous les échantillons de mesure du champ magnétique, une étape de sélection des échantillons peut intervenir en amont.

La fonction de coût peut alors être minimisée par rapport aux biais $B_b$ et $H_b$ (ou $v2g(H_b)$) par une méthode algorithmique quelconque, par exemple un algorithme itératif de Newton, Gauss-Newton, Levenberg-Marquard, ... etc. afin d'obtenir les paramètres de calibration. Comme le critère (8) auquel la norme est appliquée est linéaire en les paramètres de biais, la résolution de la minimisation est très efficace. L'utilisation d'une norme robuste requiert toutefois plusieurs itérations avant convergence. Un algorithme type Gauss-Newton peut donc avantageusement être utilisé. Outre les méthodes basées sur une optimisation de la fonction de coût de type descente de gradient, d'autres approches peuvent être utilisées pour minimiser la fonction de coût, comme par exemple avec des outils du type observateurs d'état (filtre de Kalman, filtre de Kalman étendu, observateur de Luenberger ou autre). On peut ainsi par exemple construire un filtre de Kalman étendu à partir de la prédiction (8) où la matrice de covariance de l'erreur représente la fonction de coût à minimiser.

L'exemple ci-dessus a été simplifié à un cas où les seuls paramètres à calibrer sont des biais magnétométriques constants. La même approche peut également être employée pour déterminer d'autres paramètres de calibration, tels que des facteurs d'échelle des mesures, ou des paramètres de configuration spatiale du magnétomètre, comme par exemple les positions orientation du magnétomètre par rapport au point solidaire du magnétomètre pour lequel les informations de trajectoire sont fournies. Cette méthode permet donc d'estimer la géométrie d'un réseau de magnétomètres. Il est également possible d'utiliser la minimisation de la fonction de coût pour déterminer les paramètres d'un modèle paramétrique du champ magnétique dans lequel évolue le magnétomètre 2 lorsqu'il parcourt les positions de parcours.

Ainsi qu'indiqué plus haut, le procédé peut être avantageusement employé pour calibrer plusieurs magnétomètres 2 en même temps, en particulier quand ceux-ci sont intégrés à une centrale magnéto-inertielle 1. Dans l'exemple ci-dessous, plusieurs magnétomètres 2 forment un réseau, et les paramètres à calibrer visent à compenser non seulement un ou biais magnétométrique affectant la mesure du champ magnétique, mais également des facteurs d'échelle. On suppose qu'une mesure d'un magnétomètre 2 i d'un réseau est décrite d'une façon linéaire selon l'équation.

$$\mathbf{B_{mi}} = \mathbf{D}_i \mathbf{B} + \mathbf{b_i} \qquad (10)$$

Où $\mathbf{B}$ est le champ magnétique réel et $\mathbf{B_{mi}}$ la mesure du champ magnétique du magnétomètre i (polluée par un facteur d'échelle $\mathbf{D}_i$ qui peut être diagonal ou une matrice pleine et un biais $\mathbf{b_i}$). Il est à noter toutefois que d'autres paramètres magnétométriques pourraient être utilisés de manière similaire.

En reprenant la relation exprimée par l'équation (1), avec une modélisation locale au premier ordre du champ magnétique autour d'un magnétomètre 2 de référence (indicé 0) du réseau, le magnétomètre 2i à la position $\mathbf{dx_i}$ d'un ensemble de magnétomètres positionnés dans un volume proche donne la mesure du champ magnétique $\mathbf{B_{mi}}$ par le magnétomètre 2i :

$$\mathbf{B_{mi}} = \mathbf{D}_i . (\mathbf{B_0} + \nabla \mathbf{B_0} . \mathbf{dx_i}) + \mathbf{b_i} \qquad (11)$$

Avec $B_0$ le champ magnétique à la position du magnétomètre 2 de référence, et $\nabla B_0$ le gradient du champ magnétique à la position du magnétomètre 2 de référence.

On peut réécrire l'équation (11) en faisant intervenir la matrice de gradient vectorisé colonne par colonne Vec($\nabla B$):

$$\mathbf{B_{mi}} = \left( \left[ 1, \mathbf{dx_i}^T \right] \otimes \mathbf{D}_i \right) \begin{bmatrix} \mathbf{B_0} \\ \mathbf{Vec}(\nabla \mathbf{B_0}) \end{bmatrix} + \mathbf{b_i} \qquad (12)$$

où $\otimes$ représente ici le produit de Kronecker sur les matrices.

Pour un ensemble de n magnétomètres 2 tri-axes on peut concaténer les mesures et les biais magnétométriques :

$$\mathbf{B_m} = \begin{bmatrix} \left[ 1, \mathbf{dx_1}^T \right] \otimes \mathbf{D_1} \\ \vdots \\ \left[ 1, \mathbf{dx_n}^T \right] \otimes \mathbf{D_n} \end{bmatrix} \begin{bmatrix} \mathbf{B_0} \\ \mathbf{Vec}(\nabla \mathbf{B_0}) \end{bmatrix} + \mathbf{b} \qquad (13)$$

$$\mathbf{B_m} = \mathrm{diag}(\mathbf{D_1}, \ldots, \mathbf{D_n}) \begin{bmatrix} \left[ 1, \mathbf{dx_1}^T \right] \otimes \mathbf{I_{3 \times 3}} \\ \vdots \\ \left[ 1, \mathbf{dx_n}^T \right] \otimes \mathbf{I_{3 \times 3}} \end{bmatrix} \begin{bmatrix} \mathbf{B_0} \\ \mathbf{Vec}(\nabla \mathbf{B_0}) \end{bmatrix} + \mathbf{b} \qquad (14)$$

On peut alors noter

$$\mathbf{C_{mag}} = \begin{bmatrix} \left[ 1, \mathbf{dx_1}^T \right] \otimes \mathbf{I_{3 \times 3}} \\ \vdots \\ \left[ 1, \mathbf{dx_n}^T \right] \otimes \mathbf{I_{3 \times 3}} \end{bmatrix} \qquad (15)$$

La taille de $\mathbf{C_{mag}}$ vaut (n, 12). Selon le rang de la matrice $\mathbf{C_{mag}}$, il peut y avoir ou non ambiguïté sur le champ magnétique et le gradient du champ magnétique. En conséquence, la relation entre $\begin{bmatrix} \mathbf{B_0} \\ \mathbf{Vec}(\nabla \mathbf{B_0}) \end{bmatrix}$ et les mesures $\mathbf{B_m}$ peut être inversible ou non. Si le rang de la matrice est plus petit que son nombre de ligne, il est possible de réduire le nombre de paramètres du modèle de champ d'ordre 1 en prenant en compte des contraintes liés aux équations de Maxwell (le gradient est symétrique à trace nulle).

Dans ces deux cas on note $\mathbf{C_{mag}}^\dagger$ la relation linéaire qui vérifie :

$$\begin{bmatrix} \mathbf{B} \\ \mathbf{Vec}(\nabla \mathbf{B}) \end{bmatrix} = \mathbf{C_{mag}}^\dagger \mathbf{D}_{\mathrm{inv}} [\mathbf{B_m} - \mathbf{b}] \qquad (16)$$

avec $\mathbf{D}_{\mathrm{inv}} = \mathrm{diag}(\frac{1}{\mathbf{D_1}}, \ldots, \frac{1}{\mathbf{D}_n})$.

En supposant le champ magnétique stationnaire globalement, on peut écrire tout au long de la trajectoire d'un magnétomètre 2 la relation liant l'évolution du champ magnétique avec l'évolution de l'emplacement et de l'orientation dudit magnétomètre 2 :

$$\dot{\boldsymbol{B}} = -\boldsymbol{\omega} \times \mathbf{B_0} + \nabla \mathbf{B_0}.\mathbf{v} \qquad (17)$$

avec $\omega$ la vitesse de rotation du magnétomètre, et v sa vitesse de déplacement (changement d'emplacement). Il s'agit donc d'une reformulation de la relation formulée par l'équation (1).

On relie l'évolution de la mesure du champ magnétique du magnétomètre 2 de référence entre deux instants de détermination à la différence de position dérivée des informations de trajectoire. Grâce aux informations de trajectoire, on dispose de l'évolution de l'emplacement et de l'orientation des magnétomètres 2. En effet, les magnétomètres du réseau sont solidaires entre eux, et les informations de trajectoire sont représentatives de l'emplacement et de l'orientation d'un point solidaire de ces magnétomètres 2. De préférence, l'emplacement et de l'orientation du magnétomètre 2 de référence sont déterminées à partir des informations de trajectoire.

En notant $\delta \tilde{R}_{\text{pred}}$ la matrice de rotation (connue) passant de l'orientation du magnétomètre 2 de référence à l'instant de détermination précédent $t_k$ et l'orientation du même magnétomètre 2 de référence à l'instant de détermination $t_{k+1}$ et $\widetilde{dx}_{\text{pred}}$ l'emplacement (connu) de ce même magnétomètre 2 de référence à l'instant de détermination $t_{k+1}$ dans le repère formé par le même magnétomètre 2 de référence à l'instant de détermination précédent $t_k$, une estimation théorique du champ à l'instant de détermination $t_{k+1}$ s'écrit, à partir du champ magnétique et du gradient de champ magnétique à l'instant de détermination précédent $t_k$ :

$$\mathbf{B}_{k+1} = \boldsymbol{\delta} \tilde{\mathbf{R}}_{\text{pred}} (\mathbf{B}_k + \nabla \mathbf{B}_k \, \widetilde{\mathbf{dx}}_{\text{pred}}) \qquad (18)$$

L'estimation théorique peut se ramener dans l'espace des mesures (pollués par les paramètres à calibrer) du magnétomètre 2 de référence. La mesure prédite $\mathbf{B_{0pred}}(\hat{\mathbf{b}}, \hat{\mathbf{D}_i} ; \widetilde{\mathbf{dx}}_{\text{pred}}, \boldsymbol{\delta} \tilde{\mathbf{R}}_{\text{pred}}, \tilde{\mathbf{B}}_{\mathbf{m;k}})$ peut alors être exprimée en fonction des estimées du biais $\hat{\mathbf{b}}$ et du facteur d'échelle $\hat{\mathbf{D}_i}$, ainsi que des entrées $\widetilde{\mathbf{dx}}_{\text{pred}}$, $\delta \tilde{R}_{\text{pred}}$, $\tilde{\mathbf{B}}_{\mathbf{m;k}}$, avec $\tilde{\mathbf{B}}_{\mathbf{m;k}}$ la mesure du champ magnétique par le magnétomètre 2 de référence à l'instant de détermination précédent $t_k$. En effet, les mesures du champ magnétique à l'instant de détermination précédent $t_k$ permet de générer un modèle local du champ magnétique autour de la position du magnétomètre 2 de référence à l'instant de détermination précédent $t_k$:

$$\begin{bmatrix} \hat{\mathbf{B}}_{\mathbf{k}} \\ \mathbf{Vec}(\nabla \hat{\mathbf{B}}_{\mathbf{k}}) \end{bmatrix} = \hat{\mathbf{C}}_{\text{mag}}^{\dagger} . \mathbf{D}_{\text{inv}} \begin{bmatrix} \tilde{\mathbf{B}}_{\mathbf{m;k}} - \hat{\mathbf{b}} \end{bmatrix} \qquad (19)$$

Cette modélisation locale permet de formuler une estimation théorique de la mesure du champ magnétique par le magnétomètre 2 de référence. Le passage de l'estimation théorique du champ magnétique à l'estimation théorique de la mesure du champ magnétique se fait en appliquant des estimées des paramètres de calibration, en l'occurrence l'estimée du biais magnétométrique b et l'estimée du facteur d'échelle $\hat{D}_i$ :

$$\begin{aligned} \mathbf{B_{0pred}}(\hat{\mathbf{b}}, \quad \hat{\mathbf{D}_i} ; \widetilde{\mathbf{dx}}_{\text{pred}}, \boldsymbol{\delta} \tilde{\mathbf{R}}_{\text{pred}}, \tilde{\mathbf{B}}_{\mathbf{m;k}}) &= \\ &= \hat{\mathbf{D}_0} \boldsymbol{\delta} \tilde{\mathbf{R}}_{\text{pred}} (\hat{\mathbf{B}}_k + \nabla \hat{\mathbf{B}}_k \, \widetilde{\mathbf{dx}}_{\text{pred}}) + \hat{\mathbf{b}}_0 \\ &= \hat{\mathbf{D}_0} \boldsymbol{\delta} \tilde{\mathbf{R}}_{\text{pred}} \hat{\mathbf{B}}_k + \hat{\mathbf{D}_0} \boldsymbol{\delta} \tilde{\mathbf{R}}_{\text{pred}} \nabla \hat{\mathbf{B}}_k \, \widetilde{\mathbf{dx}}_{\text{pred}} + \hat{\mathbf{b}}_0 \qquad (20) \\ &= \left( \begin{bmatrix} 1, \widetilde{\mathbf{dx}}_{\text{pred}}^{T} \end{bmatrix} \otimes \hat{\mathbf{D}_0} \boldsymbol{\delta} \tilde{\mathbf{R}}_{\text{pred}} \right) \begin{bmatrix} \hat{\mathbf{B}}_{\mathbf{k}} \\ \mathbf{Vec}(\nabla \hat{\mathbf{B}}_{\mathbf{k}}) \end{bmatrix} + \hat{\mathbf{b}}_0 \end{aligned}$$

En injectant (19) dans (20), on obtient la relation liant l'estimation de la mesure à l'instant de détermination $t_{k+1}$ aux mesures à l'instant de détermination précédent $t_k$ et aux paramètres du modèle de chaque magnétomètre 2 :

$$\mathbf{B_{0pred}} \left( \begin{bmatrix} 1, \widetilde{\mathbf{dx}}_{\text{pred}}^{T} \end{bmatrix} \otimes \hat{\mathbf{D}_0} \boldsymbol{\delta} \tilde{\mathbf{R}}_{\text{pred}} \right) \begin{bmatrix} \hat{\mathbf{C}}_{\text{mag}}^{\dagger} \mathbf{D}_{\text{inv}} \begin{bmatrix} \tilde{\mathbf{B}}_{\mathbf{m;k}} - \hat{\mathbf{b}} \end{bmatrix} \end{bmatrix} + \hat{\mathbf{b}}_0 \qquad (21)$$

Cette relation permet de construire la prédiction suivante :

$$\begin{aligned} \mathbf{B_{0pred}}(\hat{\mathbf{b}}, \hat{\mathbf{D}_i} ; \widetilde{\mathbf{dx}}_{\text{pred}}, \boldsymbol{\delta} \tilde{\mathbf{R}}_{\text{pred}}, \tilde{\mathbf{B}}_{\mathbf{m;k}}) &= \\ \left( \begin{bmatrix} 1, \widetilde{\mathbf{dx}}_{\text{pred}}^{T} \end{bmatrix} \otimes \hat{\mathbf{D}_0} \boldsymbol{\delta} \tilde{\mathbf{R}}_{\text{pred}} \right) &\begin{bmatrix} \hat{\mathbf{C}}_{\text{mag}}^{\dagger} \mathbf{D}_{\text{inv}} \begin{bmatrix} \tilde{\mathbf{B}}_{\mathbf{m;k}} - \hat{\mathbf{b}} \end{bmatrix} \end{bmatrix} + \hat{\mathbf{b}}_0 \end{aligned} \qquad (22)$$

On peut alors construire la fonction de coût à partir des résidus dans l'espace de mesure de la façon suivante :

$$\sum_k \rho \left( \mathbf{B_{k+1;0pred;k+1;}}(\hat{\mathbf{b}}, \hat{\mathbf{D}}_\mathbf{i} ; \widetilde{\mathbf{dx}}_{\text{pred}}, \delta \widetilde{\mathbf{R}}_{\text{pred}}, \widetilde{\mathbf{B}}_{\mathbf{m;k}}) - \widetilde{\mathbf{B}}_{m;k+1} \right) \qquad (23)$$

où comme précédemment, p est une norme qui peut être la norme L2, la norme L1 ou une autre norme, et $\widetilde{\mathbf{B}}_{m;k+1}$ représente la mesure du champ magnétique par un magnétomètre, polluée par un facteur d'échelle et un biais. La somme peut ne pas contenir tous les échantillons de mesure du champ magnétique, une étape de sélection des échantillons pouvant intervenir en amont. La fonction de coût peut alors être minimisée par rapport aux estimées (notées avec un accent circonflexe ici) par une méthode algorithmique quelconque, par exemple un algorithme itératif de Newton, Gauss-Newton, Levenberg-Marquard, ... etc. afin d'obtenir les paramètres de calibration. Comme précédemment, outre les méthodes basées sur une optimisation de la fonction de coût de type descente de gradient, d'autres approches peuvent être utilisées pour minimiser la fonction de coût, comme par exemple avec des outils du type observateurs d'état (filtre de Kalman, filtre de Kalman étendu, observateur de Luenberger ou autre). On peut ainsi par exemple construire un filtre de Kalman étendu à partir de la prédiction (22) où la matrice de covariance de l'erreur représente la fonction de coût à minimiser.

Il est à noter que le minimum de la fonction de coût formulée par l'équation (23) peut ne pas être unique. Les minimums correspondent alors à des situations dégénérées. Par exemple, il peut être montré que dans certains cas certaines combinaisons linéaires des biais magnétométriques ne sont pas observables, même si on cherche à n'estimer que ceux-ci (par exemple en supposant les facteurs d'échelle à l'unité). Dans ce cas, on peut facilement reparamétriser l'influence des biais magnétométrique dans la fonction de coût formulée par l'équation (23) sur un sous-espace observable en faisant le changement de variable suivant :

$$\hat{\mathbf{b}}' \leftarrow \left[ \mathbf{b_0}; [\hat{\mathbf{C}}_{\text{mag}}]_{4:8} \mathbf{D}_{\text{inv}} \hat{\mathbf{b}} \right]^T \qquad (24)$$

où la notation $[X]_{i:j}$ correspond à la sous-matrice formée par les lignes de X dont l'index se trouve entre i et j inclus. Cela revient à ramener la fonction de coût (24) à la fonction de coût formulée en (9). Il peut être également nécessaire de fixer au moins un des facteurs d'échelle, ou bien un facteur d'échelle moyen global pour rejeter la situation dégénérée dans laquelle tous les facteurs d'échelle sont identiquement nuls. D'autres solutions aux problèmes de non-unicité, telle la régularisation permettent d'éviter que la non-unicité du minimum n'affecte la convergence de l'algorithme. Ces méthodes par régularisation agissent au niveau du procédé de minimisation en limitant la modification de l'estimée le long d'une direction ne faisant pas varier la fonction de coût. Ces remarques s'appliquent aux différentes formulations des fonctions de coût.

L'exemple ci-dessus est donné à titre d'exemple non limitatif pour le cas d'un réseau de magnétomètres 2 tri-axes. On pourrait également envisager de considérer un réseau de magnétomètres 2 mono-axes. Le modèle de mesure exprimé par (10) devient alors, pour chacun des axes :

$$B_{mi} = \mathbf{f_i}^T . \mathbf{B} + b_i \qquad (25)$$

où B est le champ magnétique réel et $\mathbf{B_{mi}}$ la mesure du champ magnétique, $\mathbf{f_i}$ un vecteur de dimension 3, associé à la sensibilité du capteur et $b_i$ le biais de ce capteur. Dans ce cas, avec le même raisonnement que celui présenté dans le cas du réseau de magnétomètres 2 tri-axes, il est possible de déduire une fonction de coût similaire qui dépend en plus des nouveaux paramètres :

$$\sum_k \rho \left( \mathbf{B_{k+1;0pred;k+1}}(\hat{\mathbf{b}}, \hat{\mathbf{f_i}} ; \widetilde{\mathbf{dx}}_{\text{pred}}, \delta \widetilde{\mathbf{R}}_{\text{pred}}, \widetilde{\mathbf{B}}_{\mathbf{m;k}}) - \widetilde{\mathbf{B}}_{\mathbf{m;k+1}} \right) \qquad (26)$$

Les exemples ci-dessus exploitent la relation établie par l'équation de la dérivée particulaire du champ magnétique 1, éventuellement avec une approximation locale du premier ordre comme dans (11). Il est cependant possible d'adopter une approche plus simple lorsque le champ magnétique dans lequel s'effectue le parcours du magnétomètre 2 est stationnaire, c'est-à-dire indépendant du temps mais dépendant de l'espace.

Supposons que l'on dispose de n magnétomètres 2 mono-axes et à réponse affine placés rigidement sur une carte capteur, comme dans le cas d'une centrale magnéto-inertielle 1. Les mesures de ces magnétomètres 2 peuvent être modélisés par :

$$m_i(B) = \langle a_i | B \rangle + b_i \qquad (27)$$

où $a_i$ représente les trois paramètres de calibration du magnétomètre 2 mono-axe $i$ associés à sa réponse linéaire par rapport au champ magnétique $B$ exprimés en repère capteur, et $b_i$ est un scalaire représentant le biais du magnétomètre 2 monoaxe i. Chaque magnétomètre 2 étant placé à une position différente sur la carte capteur, si l'on note $x_i$ le vecteur représentant la position dans un repère fixe par rapport à la carte capteur, alors on peut écrire en première approximation qu'à tout instant de détermination $t_k$ :

$$m_i(B, t_k) = \langle a_i | B(x_i, t_k) \rangle + b_i \qquad (28)$$

où B représente le champ magnétique en repère capteur en fonction de la position et du temps. Lorsque la carte capteur est mise en mouvement dans un champ magnétique supposé stationnaire (indépendant du temps, mais dépendant de l'espace) pour parcourir un ensemble de positions de parcours, le champ magnétique B vu dans le repère du magnétomètre 2 ne dépend que de l'emplacement et de l'orientation de la carte capteur dans l'espace. Puisque ces emplacements et orientations sont connues par les informations de trajectoire fournies, simultanément aux mesures du champ magnétique issues des magnétomètres 2 pour chaque instant de détermination, alors les paramètres $a_i$, $x_i$, et $b_i$, sont observables, à un facteur d'échelle global près pour les paramètres $a_i$ correspondant à l'unité de champ magnétique, dès lors que le système est placé dans un champ stationnaire inhomogène, c'est à dire qu'il dépend de l'espace. Il est à noter toutefois que le facteur d'échelle global pour les paramètres $a_i$, qui correspond à un étalonnage du système de mesure sur une unité de champ magnétique, peut être superflu pour certaines applications, telles qu'un tachymètre magnétique d'une centrale magnéto-inertielle 1 ou le calcul du cap.

Une fonction de coût possible à minimiser peut alors être de formule générale

$$E = \sum_j \rho \left( m_i(t_j) - \left( \langle a_i | B(x_i, t_j) \rangle + b_i \right) \right) \qquad (29)$$

où $m_i(t_j)$ représente la mesure au temps de détermination $t_j$ issue du magnétomètre 2i, pour les paramètres $a_i$, $x_i$, et $b_i$ et une description du champ magnétique B stable dans la référence de position, et p une norme comme précédemment expliqué.

A titre d'exemple, si le gradient du champ magnétique est considéré comme spatialement constant, le champ magnétique peut être décrit par un modèle affine.

En notant u la variable spatiale décrivant l'emplacement dans le repère extérieur, on peut décrire le champ magnétique comme étant :

$$B_0(u) = B_0(0) + \nabla B(0).u \qquad (30)$$

où $B_0(0)$ est un vecteur constant représentant le champ magnétique à une position de référence, et VB(0) est une matrice symétrique à trace nulle représentant le gradient de champ magnétique à la position de référence.

En notant

- $O(t_j)$ la position de l'origine du repère capteur dans le référentiel extérieur à l'instant $t_j$,
- $R(t_j)$ la matrice de rotation représentant l'orientation de la carte capteurs par rapport au référentiel extérieur à l'instant $t_j$,
- $B_0(u)$ le champ magnétique en repère extérieur fonction de u,

on peut écrire :

$$B(x_i, t_j) = R^T(t_j) B_0(O(t_j) + R(t_j)x_i) \qquad (31)$$

En combinant l'équation (30) avec l'équation (31), il vient :

$$B(x_i, t_j) = R^T(t_j) \left( B_0(0) + \nabla B(0).(O(t_j) + R(t_j)x_i) \right) \qquad (32)$$

Cette expression (32) peut être injectée dans la fonction coût E donnée en exemple dans l'expression (29). Par exemple, avec ρ la norme L2 au carré, on obtient :

$$E = \sum_j \left( m_i(t_j) - \left( \left\langle a_i \middle| R^T(t_j) \left( B_0(0) + \nabla B(0) . \left( O(t_j) + R(t_j) x_i \right) \right) \right\rangle + b_i \right) \right)^2 \quad (33)$$

En minimisant la fonction coût, on peut ainsi non seulement déterminer les facteurs d'échelle et d'orientation $a_i$ et les biais $b_i$, mais également identifier en guise de description du champ les trois paramètres indépendants $B_0(0)$ et les cinq paramètres indépendants de $\nabla B(0)$. On peut donc procéder sans aucune information sur le champ magnétique autre que sa stationnarité, puisque les paramètres du modèle du champ magnétique sont déterminés via la fonction de coût.

La méthode peut également être appliquée similairement en utilisant d'autres modèles de champ magnétique en tant que relation liant l'évolution d'un champ magnétique avec l'évolution de l'emplacement et de l'orientation du magnétomètre. Ainsi, on peut utiliser des modèles de champ magnétique avec un développement à des ordres plus élevés, en estimant par exemple la hessienne de ce champ magnétique ou les dérivées d'ordres plus élevés.

Une fois les paramètres de calibration d'un magnétomètre 2 déterminés, il suffit d'appliquer aux mesures du magnétomètre 2 des corrections résultant des paramètres de calibration pour calibrer le magnétomètre (étape S6). Par exemple, pour compenser un biais magnétométrique b, il suffit de soustraire de la mesure la valeur de biais b déterminée lors de la calibration.

Il est à noter que le présent procédé de calibration peut être mis en œuvre non seulement lors d'un étalonnage du magnétomètre préalable à son utilisation, mais également lors de l'utilisation du magnétomètre, afin de recalibrer celui-ci en cours d'utilisation. Il suffit en effet de disposer des informations de trajectoire. C'est notamment le cas pour une centrale magnéto-inertielle.

L'invention concerne également un produit programme d'ordinateur comprenant des instructions de code de programme enregistrées sur un support non-volatile lisible par un ordinateur pour l'exécution des étapes du procédé selon l'invention lorsque lesdites instructions de code programme sont exécutées sur un ordinateur. L'invention n'est pas limitée au mode de réalisation décrit et représenté aux figures annexées. Des modifications restent possibles, notamment du point de vue de la constitution des divers caractéristiques techniques, sans sortir pour autant du domaine de protection de l'invention, comme définie par les revendications.

**Revendications**

1. Procédé de calibration d'un magnétomètre (2) comprenant les étapes suivantes :

    - le magnétomètre (2) parcourt (S1) un ensemble de positions de parcours, lesdites positions se distinguant entre elles par un emplacement du magnétomètre (2) et/ou par une orientation du magnétomètre (2) ;
    - acquisition(S2) par le magnétomètre (2) à des instants d'acquisition d'une pluralité de mesures du champ magnétique lorsque le magnétomètre (2) parcourt ledit ensemble de positions de parcours ;
    - fourniture d'informations de trajectoire (S3) représentatives de l'emplacement et de l'orientation d'un point solidaire du magnétomètre (2) au cours du parcours de l'ensemble de positions de parcours à des instants de parcours,
    - pour chacun d'une pluralité d'instants de détermination déterminés à partir des instants d'acquisition et des instants de parcours, mise en correspondance (S4) des mesures du champ magnétique avec les informations de trajectoire,
    - détermination (S5) de paramètres de calibration du magnétomètre (2) par la minimisation d'une fonction de coût faisant intervenir, pour une pluralité d'instants de détermination, au moins lesdits paramètres de calibration, une mesure du champ magnétique, et une relation liant l'évolution d'un champ magnétique avec l'évolution de l'emplacement et de l'orientation du magnétomètre (2) dérivée des informations de trajectoire, la relation liant l'évolution d'un champ magnétique avec l'évolution de l'emplacement et de l'orientation du magnétomètre traduisant localement une équation de la dérivée particulaire du champ magnétique :

$$\dot{\vec{B}} = \nabla\vec{B}.\vec{v} + \Omega \times \vec{B}$$

avec $\vec{B}$ un vecteur champ magnétique, $\nabla\vec{B}$ un vecteur gradient du champ magnétique, $\dot{\vec{B}}$ un vecteur de la dérivée temporelle du champ magnétique, $\vec{v}$ un vecteur vitesse représentatif de la modification de l'emplacement et $\Omega$ une matrice de rotation représentative de la modification de l'orientation.

2. Procédé selon la revendication 1, dans lequel la fonction de coût fait intervenir des termes d'erreur concernant de mesures capteurs, lesdites mesures capteurs prises seules permettant d'obtenir les informations de trajectoire, les informations de trajectoire étant alors déterminées en même temps que les paramètres de calibration.

3. Procédé selon l'une des revendications précédentes, dans lequel la minimisation de la fonction de coût est effectuée avec un observateur d'état.

4. Procédé selon l'une des revendications précédentes, dans lequel la fonction de coût est basée sur des comparaisons entre une estimation théorique de la mesure du champ magnétique à un instant de détermination et une mesure du champ magnétique audit instant de détermination, l'estimation théorique du champ magnétique prenant en compte les paramètres de calibration.

5. Procédé selon la revendication 4, dans lequel l'estimation théorique de la mesure du champ magnétique est déterminée à partir de la relation liant l'évolution d'un champ magnétique avec l'évolution de l'emplacement et de l'orientation du magnétomètre dérivée des informations de trajectoire.

6. Procédé selon l'une des revendications 4 à 5, dans lequel l'estimation théorique de la mesure du champ magnétique est déterminée au moins à partir :

- d'une mesure du champ magnétique à un instant de détermination précédent,
- de l'évolution de l'emplacement et de l'orientation d'un point solidaire du magnétomètre (2) entre l'instant de détermination et l'instant de détermination précédent, déterminées à partir des informations de trajectoire,
- des paramètres de calibration.

7. Procédé selon la revendication précédente, comprenant également une acquisition à des instants d'acquisition d'une pluralité de mesures d'un gradient du champ magnétique lorsque le magnétomètre (2) parcourt ledit ensemble de positions de parcours, et l'estimation théorique du champ magnétique est également déterminée à partir d'une mesure du gradient du champ magnétique à l'instant de détermination précédent.

8. Procédé selon la revendication 4 ou 5, dans lequel l'estimation théorique de la mesure du champ magnétique à un instant de détermination est déterminée à partir :

- d'une grandeur du champ magnétique en un point de référence,
- d'un gradient du champ magnétique audit point de référence, et
- de la différence entre l'emplacement du point solidaire du magnétomètre et un emplacement du point de référence,
- de la rotation entre l'orientation du point solidaire du magnétomètre et une orientation au point de référence,

la grandeur du champ magnétique en un point de référence et le gradient du champ magnétique audit point de référence étant déterminé par la minimisation de la fonction de coût.

9. Procédé selon l'une quelconque des revendications précédentes, dans lequel les paramètres de calibration comprennent :

- un premier biais magnétométrique affectant la mesure du champ magnétique, et/ou
- un second biais magnétométrique affectant une mesure d'un gradient du champ magnétique, et/ou
- un paramètre d'échelle affectant une amplitude de la mesure du champ magnétique et/ou
- des paramètres de configuration spatiale du magnétomètre.

10. Procédé selon l'une quelconque des revendications précédentes, dans lequel la mise en correspondance consiste à interpoler au moins un ensemble parmi :

- un ensemble des mesures du champ magnétique et du gradient de champ magnétique,
- un ensemble des informations de trajectoire,

de sorte qu'à chaque instant de détermination corresponde au moins une mesure du champ magnétique et des informations de trajectoire.

11. Procédé selon l'une quelconque des revendications précédentes, dans lequel les informations de trajectoire sont fournies par l'utilisation d'un imageur (10) repérant l'emplacement et l'orientation du magnétomètre (2) à chaque instant de parcours lorsque le magnétomètre parcourt le premier ensemble de position.

12. Procédé selon la revendication précédente, dans lequel l'imageur (10) est solidaire du magnétomètre (2), et une mire (11) fixe est disposée dans un champ de vision dudit imageur, les informations de trajectoire étant dérivées du repérage de la mire dans des images acquises par l'imageur lorsque le magnétomètre parcourt l'ensemble de positions de parcours.

13. Procédé selon l'une quelconque des revendications 1 à 10, dans lequel un dispositif de déplacement mécanique déplace le magnétomètre (2) d'une position à une autre position dans le premier ensemble de position lorsque le magnétomètre parcourt ledit ensemble de positions de parcours, les informations de trajectoire étant dérivées de mesures de positions dudit dispositif de déplacement mécanique ou de consignes de positions dudit dispositif de déplacement mécanique.

14. Procédé selon l'une quelconque des revendications 1 à 10, dans lequel le magnétomètre (2) est solidaire de capteurs inertiels (24) configurés pour déterminer à chacun des instants de parcours des accélérations et des vitesses angulaires, et les informations de trajectoires sont dérivées desdites accélérations et des vitesses angulaires.

15. Procédé selon l'une quelconque des revendications précédentes, dans lequel le magnétomètre (2) est disposé dans une centrale magnéto-inertielle (1).

16. Unité de traitement automatisé de données comprenant un processeur, une mémoire et des interfaces d'entrée et de sortie, configurée pour :

   - recevoir une pluralité de mesures du champ magnétique acquises à des instants d'acquisition par un magnétomètre (2) parcourant un ensemble de positions de parcours, lesdites se distinguant entre elles par l'emplacement spatial du magnétomètre et/ou par l'orientation du magnétomètre ;
   - recevoir des informations de trajectoire représentatives de l'emplacement et de l'orientation d'un point solidaire du magnétomètre (2) au cours du parcours des positions de l'ensemble de positions de parcours à des instants de parcours,
   - pour chacun d'une pluralité d'instants de détermination déterminés à partir des instants d'acquisition et des instants de parcours, mettre en correspondance des mesures du champ magnétique et du gradient de champ magnétique avec les informations de trajectoire,
   - déterminer des paramètres de calibration du magnétomètre par la minimisation d'une fonction de coût faisant intervenir, pour une pluralité d'instants de détermination, au moins lesdits paramètres de calibration, une mesure du champ magnétique, et une relation liant l'évolution d'un champ magnétique avec l'évolution de l'emplacement et de l'orientation du magnétomètre dérivée des informations de trajectoire, la relation liant l'évolution d'un champ magnétique avec l'évolution de l'emplacement et de l'orientation du magnétomètre traduisant localement une équation de la dérivée particulaire du champ magnétique :

$$\dot{\vec{B}} = \nabla \vec{B} . \vec{v} + \Omega \times \vec{B}$$

avec $\vec{B}$ un vecteur champ magnétique, $\nabla \vec{B}$ un vecteur gradient du champ magnétique, $\dot{\vec{B}}$ un vecteur de la dérivée temporelle du champ magnétique, $\vec{v}$ un vecteur vitesse représentatif de la modification de l'emplacement et $\Omega$ une matrice de rotation représentative de la modification de l'orientation.

17. Produit programme d'ordinateur comprenant des instructions de code de programme enregistrées sur un support non-volatile lisible par un ordinateur qui conduisent l'appareil selon la revendication 16 à exécuter les étapes du procédé selon les revendications 1 à 15.

**Patentansprüche**

1. Verfahren zur Kalibrierung eines Magnetometers (2), das die folgenden Schritte umfasst:

   - das Magnetometer (2) eine Menge von Wegpositionen durchläuft (S1), wobei die Positionen sich untereinander durch eine Lage des Magnetometers (2) und/oder durch eine Ausrichtung des Magnetometers (2) unterscheiden;
   - durch das Magnetometer (2), Erfassen (S2) einer Vielzahl von Messungen des Magnetfelds an Erfassungszeitpunkten, wenn das Magnetometer (2) die Menge von Wegpositionen durchläuft;
   - Liefern von Bewegungsbahninformationen (S3), die für die Lage und die Ausrichtung eines Punkts repräsentativ sind, der fest mit dem Magnetometer (2) verbunden ist, während des Durchlaufens der Menge der Wegpositionen an Wegzeitpunkten,
   - für jeden von einer Vielzahl von Bestimmungszeitpunkten, die ausgehend von den Erfassungszeitpunkten und den Wegzeitpunkten bestimmt werden, Mapping (S4) der Messungen des Magnetfelds mit den Bewegungsbahninformationen,
   - Bestimmen (S5) von Parametern zur Kalibrierung des Magnetometers (2) durch Minimieren einer Kostenfunktion, die für eine Vielzahl von Bestimmungszeitpunkten zumindest die Kalibrierungsparameter, eine Messung des Magnetfelds und eine Beziehung einsetzt, die die Entwicklung eines Magnetfelds mit der Entwicklung der Lage und der Ausrichtung des Magnetometers (2) verbindet, die von den Bewegungsbahninformationen abgeleitet wird, wobei die Beziehung die Entwicklung eines Magnetfelds mit der Entwicklung der Lage und der Ausrichtung des Magnetometers verbindet, die lokal eine Gleichung der bestimmten Ableitung des Magnetfelds ausdrückt:

$$\dot{\vec{B}} = \nabla\vec{B}.\vec{v} + \Omega \times \vec{B}$$

   wobei $\vec{B}$ ein Magnetfeldvektor, $\nabla\vec{B}$ ein Gradientenvektor des Magnetfelds, $\dot{\vec{B}}$ ein Vektor der zeitlichen Ableitung des Magnetfelds, $\vec{v}$ ein Geschwindigkeitsvektor, der für die Änderung der Lage repräsentativ ist, und $\Omega$ eine Drehmatrix ist, die für die Änderung der Ausrichtung repräsentativ ist.

2. Verfahren nach Anspruch 1, wobei die Kostenfunktion Fehlerterme einsetzt, die Sensormessungen betreffen, wobei die Sensormessungen allein das Erhalten der Bewegungsbahninformationen erlauben, wobei die Bewegungsbahninformationen dann gleichzeitig mit den Kalibrierungsparametern bestimmt werden.

3. Verfahren nach einem der vorhergehenden Ansprüche, wobei die Minimierung der Kostenfunktion mit einem Zustandsbeobachter durchgeführt wird.

4. Verfahren nach einem der vorhergehenden Ansprüche, wobei die Kostenfunktion auf Vergleichen zwischen einer theoretischen Schätzung der Messung des Magnetfelds an einem Bestimmungszeitpunkt und einer Messung des Magnetfelds an dem Bestimmungszeitpunkt basiert, wobei die theoretische Schätzung des Magnetfelds die Kalibrierungsparameter berücksichtigt.

5. Verfahren nach Anspruch 4, wobei die theoretische Schätzung der Messung des Magnetfelds ausgehend von der Beziehung bestimmt wird, die die Entwicklung eines Magnetfelds mit der Entwicklung der Lage und der Ausrichtung des Magnetometers verbindet, die von den Bewegungsbahninformationen abgeleitet wird.

6. Verfahren nach einem der Ansprüche 4 bis 5, wobei die theoretische Schätzung der Messung des Magnetfelds zumindest basierend auf Folgendem bestimmt wird:

   - einer Messung des Magnetfelds an einem vorhergehenden Bestimmungszeitpunkt,
   - der Entwicklung der Lage und der Ausrichtung eines Punkts, der fest mit dem Magnetometer (2) verbunden ist, zwischen dem Bestimmungszeitpunkt und dem vorhergehenden Bestimmungszeitpunkt, die ausgehend von den Bewegungsbahninformationen bestimmt werden,
   - Kalibrierungsparametern.

7. Verfahren nach dem vorhergehenden Anspruch, das auch eine Erfassung einer Vielzahl von Messungen eines Gradienten des Magnetfelds an Erfassungszeitpunkten umfasst, wenn das Magnetometer (2) die Menge von Wegpositionen durchläuft, und die theoretische Schätzung des Magnetfelds auch ausgehend von einer Messung des Gradienten des Magnetfelds am vorhergehenden Bestimmungszeitpunkt bestimmt wird.

8. Verfahren nach Anspruch 4 oder 5, wobei die theoretische Schätzung der Messung des Magnetfelds an einem Bestimmungszeitpunkt ausgehend von Folgendem bestimmt wird:

- einer Größe des Magnetfelds an einem Bezugspunkt,
- einem Gradienten des Magnetfelds an dem Bezugspunkt, und
- der Differenz zwischen der Lage des Punkts, der fest mit dem Magnetometer verbunden ist, und einer Lage des Bezugspunkts,
- der Drehung zwischen der Ausrichtung des Punkts, der fest mit dem Magnetometer verbunden ist, und einer Ausrichtung am Bezugspunkt,

wobei die Größe des Magnetfelds an einem Bezugspunkt und der Gradient des Magnetfelds an dem Bezugspunkt durch die Minimierung der Kostenfunktion bestimmt werden.

9. Verfahren nach einem der vorhergehenden Ansprüche, wobei die Kalibrierungsparameter umfassen:

- eine erste magnetometrische Verzerrung, die die Messung des Magnetfelds beeinträchtigt, und/oder
- eine zweite magnetometrische Verzerrung, die eine Messung eines Gradienten des Magnetfelds beeinträchtigt, und/oder
- einen Skalierungsparameter, der eine Amplitude der Messung des Magnetfelds beeinträchtigt, und/oder
- Parameter der räumlichen Ausgestaltung des Magnetometers.

10. Verfahren nach einem der vorhergehenden Ansprüche, wobei das Mapping im Interpolieren von mindestens einer Menge unter Folgendem besteht:

- einer Menge von Messungen des Magnetfelds und des Magnetfeldgradienten,
- einer Menge von Bewegungsbahninformationen,

derart, dass jedem Bestimmungszeitpunkt mindestens eine Magnetfeldmessung und Bewegungsbahninformationen entsprechen.

11. Verfahren nach einem der vorhergehenden Ansprüche, wobei die Bewegungsbahninformationen durch die Verwendung eines Bildaufnehmers (10) geliefert werden, der die Lage und die Ausrichtung des Magnetometers (2) an jedem Wegzeitpunkt ermittelt, wenn das Magnetometer die erste Positionsmenge durchläuft.

12. Verfahren nach dem vorhergehenden Anspruch, wobei der Bildaufnehmer (10) fest mit dem Magnetometer (2) verbunden ist, und ein festes Ziel (11) in einem Gesichtsfeld des Bildaufnehmers angeordnet ist, wobei die Bewegungsbahninformationen von der Ermittlung des Ziel in den Bildern abgeleitet werden, die von dem Bildaufnehmer erfasst werden, wenn das Magnetometer die Menge von Wegpositionen durchläuft.

13. Verfahren nach einem der Ansprüche 1 bis 10, wobei eine mechanische Verlagerungsvorrichtung das Magnetometer (2) von einer Position zu einer anderen Position in der ersten Positionsmenge verlagert, wenn das Magnetometer die Menge von Wegpositionen durchläuft, wobei die Bewegungsbahninformationen von Positionsmessungen der mechanischen Verlagerungsvorrichtung oder Einstellwerten von Positionen der mechanischen Verlagerungsvorrichtung abgeleitet werden.

14. Verfahren nach einem der Ansprüche 1 bis 10, wobei das Magnetometer (2) fest mit Trägheitssensoren (24) verbunden ist, die ausgestaltet sind, um an jedem der Wegzeitpunkte Beschleunigungen und Winkelgeschwindigkeiten zu bestimmen, und die Weginformationen von den Beschleunigungen und den Winkelgeschwindigkeiten abgeleitet werden.

15. Verfahren nach einem der vorhergehenden Ansprüche, wobei das Magnetometer (2) in einer Magnet-Trägheitsstation (1) angeordnet ist.

16. Einheit zur automatisierten Datenverarbeitung, die einen Prozessor, einen Speicher und Eingangs- und Ausgangsschnittstellen umfasst und die ausgestaltet ist zum:

- Empfangen einer Vielzahl von Messungen des Magnetfelds, die an Erfassungszeitpunkten von einem Magnetometer (2) erfasst werden, der eine Menge von Wegpositionen durchläuft, die sich durch die räumliche Lage des Magnetometers und/oder durch die Ausrichtung des Magnetometers voneinander unterscheiden;

- Empfangen von Bewegungsbahninformationen, die für die Lage und die Ausrichtung eines Punkts repräsentativ sind, der fest mit dem Magnetometer (2) verbunden ist, während des Durchlaufens der Positionen der Menge von Wegpositionen an Wegzeitpunkten,

- für jeden von einer Vielzahl von Bestimmungszeitpunkten, die ausgehend von den Erfassungszeitpunkten und den Wegzeitpunkten bestimmt werden, Mapping der Messungen des Magnetfelds und des Magnetfeldgradienten mit den Bewegungsbahninformationen,

- Bestimmen von Parametern zur Kalibrierung des Magnetometers durch Minimieren einer Kostenfunktion, die für eine Vielzahl von Bestimmungszeitpunkten zumindest die Kalibrierungsparameter, eine Messung des Magnetfelds und eine Beziehung einsetzt, die die Entwicklung eines Magnetfelds mit der Entwicklung der Lage und der Ausrichtung des Magnetometers verbindet, die von den Bewegungsbahninformationen abgeleitet wird, wobei die Beziehung die Entwicklung eines Magnetfelds mit der Entwicklung der Lage und der Ausrichtung des Magnetometers verbindet, die lokal eine Gleichung der bestimmten Ableitung des Magnetfelds ausdrückt:

$$\dot{\vec{B}} = \nabla\vec{B}.\vec{v} + \Omega \times \vec{B}$$

wobei $\vec{B}$ ein Magnetfeldvektor, $\nabla\vec{B}$ ein Gradientenvektor des Magnetfelds, $\dot{\vec{B}}$ ein Vektor der zeitlichen Ableitung des Magnetfelds, $\vec{v}$ ein Geschwindigkeitsvektor, der für die Änderung der Lage repräsentativ ist, und $\Omega$ eine Drehmatrix ist, die für die Änderung der Ausrichtung repräsentativ ist.

17. Computerprogrammprodukt, das Programmcodeanweisungen umfasst, die auf einem nichtflüchtigen computerlesbaren Datenträger aufgezeichnet sind und die bewirken, dass die Vorrichtung nach Anspruch 16 die Schritte des Verfahrens nach Anspruch 1 bis 15 ausführt.

## Claims

1. Method for calibrating a magnetometer (2) including the following steps:

    - the magnetometer (2) travels through (S1) a set of path positions, said positions being distinguished from each other by a location of the magnetometer (2) and/or by an orientation of the magnetometer (2);
    - acquisition (S2) by the magnetometer (2) at acquisition times of a plurality of measurements of the magnetic field when the magnetometer (2) travels through said set of path positions;
    - provision of trajectory information (S3) representative of the location and the orientation of a point integral with the magnetometer (2) while travelling through the set of path positions at travel times,
    - for each of a plurality of determination times determined from the acquisition times and the travel times, matching up (S4) of the measurements of the magnetic field with the trajectory information,
    - determination (S5) of calibration parameters of the magnetometer (2) by the minimisation of a cost function involving, for a plurality of determination times, at least said calibration parameters, a measurement of the magnetic field, and a relationship linking the change in a magnetic field with the change in the location and in the orientation of the magnetometer (2) derived from the trajectory information, the relationship linking the change in a magnetic field with the change in the location and in the orientation of the magnetometer locally translating an equation of the particular derivative of the magnetic field:

$$\dot{\vec{B}} = \nabla\vec{B}.\vec{v} + \Omega \times \vec{B}$$

with $\vec{B}$ a magnetic field vector, $\nabla\vec{B}$ a gradient vector of the magnetic field, $\dot{\vec{B}}$ a vector of the time derivative of the magnetic field, $\vec{v}$ a velocity vector representative of the modification of the location and $\Omega$ a rotation matrix representative of the modification of the orientation.

2. Method according to claim 1, wherein the cost function involves error terms concerning sensor measurements, said sensor measurements taken alone making it possible to obtain the trajectory information, the trajectory information then being determined at the same time as the calibration parameters.

3. Method according to one of the preceding claims, wherein the minimisation of the cost function is carried out with a state observer.

4. Method according to one of the preceding claims, wherein the cost function is based on comparisons between a theoretical estimation of the measurement of the magnetic field at a determination time and a measurement of the magnetic field at said determination time, the theoretical estimation of the magnetic field taking into account the calibration parameters.

5. Method according to claim 4, wherein the theoretical estimation of the measurement of the magnetic field is determined from the relationship linking the change in a magnetic field with the change in the location and in the orientation of the magnetometer derived from the trajectory information.

6. Method according to one of claims 4 to 5, wherein the theoretical estimation of the measurement of the magnetic field is determined at least from:

- a measurement of the magnetic field at a preceding determination time,
- the change in the location and in the orientation of a point integral with the magnetometer (2) between the determination time and the preceding determination time, determined from the trajectory information,
- calibration parameters.

7. Method according to the preceding claim, also including an acquisition at acquisition times of a plurality of measurements of a gradient of the magnetic field when the magnetometer (2) travels through said set of path positions, and the theoretical estimation of the magnetic field is also determined from a measurement of the gradient of the magnetic field at the preceding determination time.

8. Method according to claim 4 or 5, wherein the theoretical estimation of the measurement of the magnetic field at a determination time is determined from:

- a strength of the magnetic field at a reference point,
- a gradient of the magnetic field at said reference point, and
- the difference between the location of the point integral with the magnetometer and the location of the reference point,
- the rotation between the orientation of the point integral with the magnetometer and an orientation at the reference point,

the strength of the magnetic field at a reference point and the gradient of the magnetic field at said reference point being determined by minimisation of the cost function.

9. Method according to any of the preceding claims, wherein the calibration parameters include:

- a first magnetometric bias affecting the measurement of the magnetic field, and/or
- a second magnetometric bias affecting a measurement of a gradient of the magnetic field, and/or
- a scale parameter affecting an amplitude of the measurement of the magnetic field and/or
- spatial configuration parameters of the magnetometer.

10. Method according to any of the preceding claims, wherein the matching up consists in interpolating at least one set among:

- a set of measurements of the magnetic field and the magnetic field gradient,
- a set of trajectory information,

such that each determination time corresponds to at least one measurement of the magnetic field and trajectory information.

11. Method according to any of the preceding claims, wherein the trajectory information is provided by the use of an imager (10) pinpointing the location and the orientation of the magnetometer (2) at each travel time when the magnetometer travels through the first set of positions.

12. Method according to the preceding claim, wherein the imager (10) is integral with the magnetometer (2), and a fixed target (11) is arranged in a field of vision of said imager, the trajectory information being derived from the pinpointing of the target in images acquired by the imager when the magnetometer travels through the set of path positions.

13. Method according to any of claims 1 to 10, wherein a mechanical displacement device displaces the magnetometer (2) from one position to another position in the first set of positions when the magnetometer travels through said set of path positions, the trajectory information being derived from position measurements of said mechanical displacement device or position set points of said mechanical displacement device.

14. Method according to any of claims 1 to 10, wherein the magnetometer (2) is integral with inertial sensors (24) configured to determine at each of the travel times accelerations and angular velocities, and the trajectory information is derived from said accelerations and angular velocities.

15. Method according to any of the preceding claims, wherein the magnetometer (2) is arranged in a magneto-inertial unit (1).

16. Automated data processing unit including a processor, a memory and input and output interfaces, configured to:

- receive a plurality of measurements of the magnetic field acquired at acquisition times by a magnetometer (2) travelling through a set of path positions, said positions being distinguished from each other by the spatial location of the magnetometer and/or by the orientation of the magnetometer;
- receive trajectory information representative of the location and the orientation of a point integral with the magnetometer (2) while travelling through the positions of the set of path positions at the travel times,
- for each of a plurality of determination times determined from the acquisition times and the travel times, matching up of the measurements of the magnetic field and the magnetic field gradient with the trajectory information,
- determining the calibration parameters of the magnetometer by minimisation of a cost function involving, for a plurality of determination times, at least said calibration parameters, a measurement of the magnetic field, and a relationship linking the change in a magnetic field with the change in the location and in the orientation of the magnetometer derived from the trajectory information, the relationship linking the change in a magnetic field with the change in the location and in the orientation of the magnetometer locally translating an equation of the particular derivative of the magnetic field:

$$\dot{\vec{B}} = \nabla\vec{B}.\vec{v} + \Omega \times \vec{B}$$

with $\vec{B}$ a magnetic field vector, $\nabla\vec{B}$ a magnetic field gradient vector, $\dot{\vec{B}}$ a vector of the temporal derivative of the magnetic field, $\vec{v}$ a velocity vector representative of the modification of the location and $\Omega$ a rotation matrix representative of the modification of the orientation.

17. A computer program product comprising program code instructions recorded on a non-volatile computer-readable medium which cause the apparatus according to claim 16 to execute the steps of the method according to claims 1 to 15.

## FIG 1

1

2

2

2

24     21     22

25

## FIG 2

1

11

10

12

13

# FIG 3

S1

| Parcours par le magnétomètre |
|---|

S3

| Fourniture d'informations de trajectoire |
|---|

S2

| Acquisition des mesures du champ magnétique |
|---|

S4

| Mise en correspondance des mesures du champ magnétique avec les informations de trajectoire |
|---|

S5

| détermination de paramètres de calibration par la minimisation d'une fonction de coût |
|---|

S6

| Calibration du magnétomètre |
|---|

**EP 3 658 921 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2914739 B1
- EP 2541199 A
- US 2014222409 A1
- FR 1756675

**Littérature non-brevet citée dans la description**

- **ZHI-QUIANG ZHANG.** Two step calibration methods for miniature inertial and magnetic sensor units. *IEEE Transactions on Industrial Electronics,* 01 Juin 2015, vol. 62 (6), 3714-3723